# EUROPEAN PATENT APPLICATION

(11) **EP 2 660 876 A1**
(43) Date of publication of application: **06.11.2013**
(21) Application number: 11854399.0
(22) Date of filing: 27.12.2011
(51) Int. Cl.: H01L 31/042

(54) **SOLAR-CELL-INTEGRATED ROLL SCREEN**

(30) Priority: 27.12.2010 JP 2010289910; 04.11.2011 JP 2011242865
(71) Applicant: Mitsubishi Chemical Corporation, Chiyoda-ku Tokyo 100-8251 (JP)
(72) Inventor: FUNAYAMA, Katsuya, Mie 510-8530 (JP); MIZUNO, Yasuko, Kanagawa 227-8502 (JP); HANDA, Keishin, Tokyo 100-8251 (JP)
(74) Representative: HOFFMANN EITLE
(86) International application number: PCT/JP2011/080340
(87) International publication number: WO 2012/091068

(57) **Abstract**

A solar-cell-integrated roll screen having a high durability against winding/unwinding. The constituent material and thickness of each section of a solar-cell-integrated roll screen are determined so that the tensile strength in the winding direction is less than or equal to 75 MPa. The constituent material and thickness of each section of the solar-cell-integrated roll screen are also preferably determined so that the Young's modulus in the winding direction is equal to or less than 650 MPa.

## Description

### Technical Field

The present invention relates to a solar-cell-integrated roll screen.

### Background Art

In recent years, solar cells come to be used at various places for the purposes of reduction of greenhouse gases emissions, etc., and besides, it is proposed to stick a solar cell module on a roll screen (curtain) (refer to, for example, Patent Literature 1-4 listed below).

### Prior Art Reference

### Patent Literature

Patent Literature 1: Japanese Laid-Open Patent Application No. 2008-42142
Patent Literature 2: Japanese Utility Model Registration No. 3143588
Patent Literature 3: Japanese Laid-Open Patent Application No. 2010-177497
Patent Literature 4: Japanese Laid-Open Patent Application No. 2000-243989

### Summary of Invention

### Technical Problem

The inventors manufactured a roll screen integrated with a thin film solar cell and found that, by repeatedly winding and unwinding the roll screen, the power generation efficiency of the solar cell decreases. Namely, an object of the present invention is to provide a solar-cell-integrated roll screen having a high durability against winding/unwinding.

### Solution to Problem

To achieve the above-mentioned object, the inventors have conducted extensive studies, and as a result have found that, although a roll screen is, in consideration of its use form, generally made using material with a high tensile strength in order to improve its durability, as for a roll screen integrated with a solar cell, the stress by a high tensile strength causes damage to the solar cell. This finding has led us to complete the present invention.

On the other hand, as the roll screen, soft fabric is used in order to facilitate storage by winding, and fabric as thin as possible is used in order to reduce its stored volume. However, we've found that the roll screen integrated with a solar cell, different from the conventional roll screen, should have some module strength in order to keep the power generation efficiency of the solar cell, and an excessively low strength causes damage to the solar cell.

Namely, the gist of the present invention is as follows.
[1] A solar-cell-integrated roll screen having a tensile strength in a winding direction less than or equal to 75 MPa.
[2] The solar-cell-integrated roll screen according to claim 1, wherein Young's modulus in the winding direction is less than or equal to 650 MPa.
[3] The solar-cell-integrated roll screen according to [1] or [2], having a thickness greater than or equal to 0.4 mm and less than or equal to 1.8 mm.
[4] The solar-cell-integrated roll screen according to any one of [1] through [3], including a surface protective layer, an encapsulation layer and a solar cell element stacked in this order.
[5] The solar-cell-integrated roll screen according to [4], wherein a thickness ratio of the encapsulation layer to the surface protective layer is less than or equal to 30.
[6] The solar-cell-integrated roll screen according to [4] or [5], wherein a product of a thickness ratio of the encapsulation layer to the surface protective layer and the Young's modulus in the winding direction is greater than or equal to 610.
[7] The solar-cell-integrated roll screen according to any one of [1] through [6], wherein the solar cell element is a thin film solar cell element.
[8] A roll screen device, comprising the solar-cell-integrated roll screen according to any one of [1] through [77].
[9] The roll screen device according to [8], further comprising a roller to wind up the solar-cell-integrated roll screen in a condition where a light receiving surface of the solar-cell-integrated roll screen faces toward outside.

### Advantageous Effects of Invention

According to the present invention, the solar-cell-integrated roll screen having a high durability against winding/unwinding can be obtained.

### Brief Description of Drawings

FIG. 1A is a block diagram of a solar-cell-integrated roll screen according to an embodiment of the present invention;
FIG. 1B is a block diagram of a solar-cell-integrated roll screen according to an embodiment of the present invention;
FIG. 1C is a block diagram of a solar-cell-integrated roll screen according to an embodiment of the present invention;
FIG. 1D is a block diagram of a solar-cell-integrated roll screen according to an embodiment of the present invention;
FIG. 1E is a block diagram of a solar-cell-integrated roll screen according to an embodiment of the present invention;
FIG. 1F is a block diagram of a solar-cell-integrated roll screen according to an embodiment of the present invention;
FIG. 1G is a block diagram of a solar-cell-integrated roll screen according to an embodiment of the present invention;
FIG. 2 is a block diagram of a roll screen device whose component is the solar-cell-integrated roll screen according to one embodiment of the present invention;
FIG. 3A is a block diagram of a roll screen device whose component is the solar-cell-integrated roll screen according to one embodiment of the present invention;
FIG. 3B is a side view of the roll screen device whose component is the solar-cell-integrated roll screen concerning one embodiment of the present invention;
FIG. 4 is am explanatory diagram of stress line obtained from tensile tests; and
FIG. 5 is a graph showing results of winding/ unwinding tests.

### Description of Embodiments

Embodiments of the present invention will hereinafter be described in detail with reference to the drawings, but the following embodiments are in no way limitative on the invention.

### 1. Solar-cell-integrated roll screen 10

Configuration (specification) of the solar-cell-integrated roll screen 10 (which will hereinafter also be termed the roll screen 10) according to the embodiment will be described.

The roll screen 10 is a unit whose indispensable component is a solar cell element 12, and it commonly includes a solar cell module 11 whose main components are an encapsulation layer 14a, the solar cell element 12 and an encapsulation layer 14b.

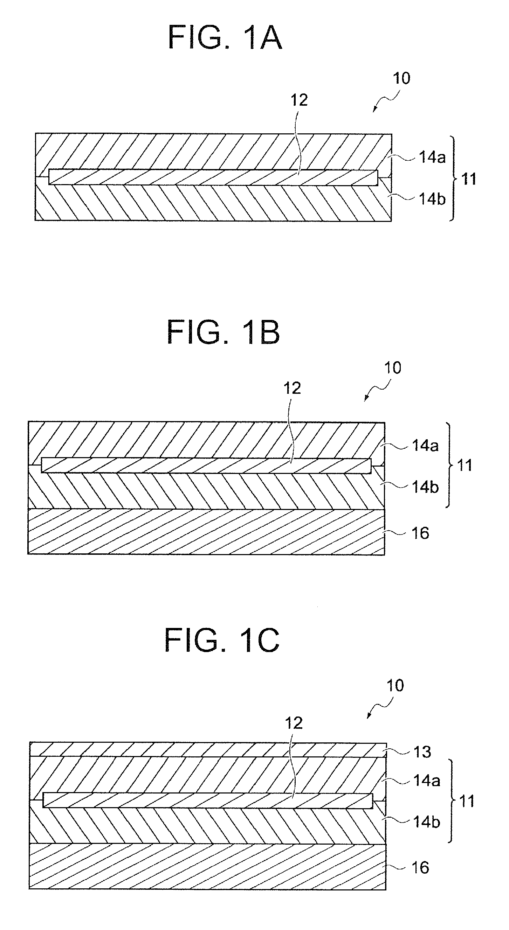

That is, as a first embodiment, there may be mentioned, as shown in FIG. 1A, a solar cell module 11 whose main components are the encapsulation layer 14a, the solar cell element 12 and the encapsulation layer 14b.

Note that the roll screen 10 may have a surface protection layer 13, a sealing material 15 and/or a backsheet 16. The backsheet 16 includes at least one layer selected from a design layer and a weatherproof layer which will be described later.

Specifically, for instance, as a second embodiment, there may be mentioned, as illustrated in FIG. 1B, a stack of the solar cell module 11 whose main components are the encapsulation layer 14a, the solar cell element 12 and the encapsulation layer 14b, and the backsheet 16.

Further, as a third embodiment, as shown in FIG. 1C, there may be mentioned a stack of the surface protection layer 13, the solar cell module 11 whose main components are the encapsulation layer 14a, the solar cell element 12 and the encapsulation layer 14b, and the backsheet 16.

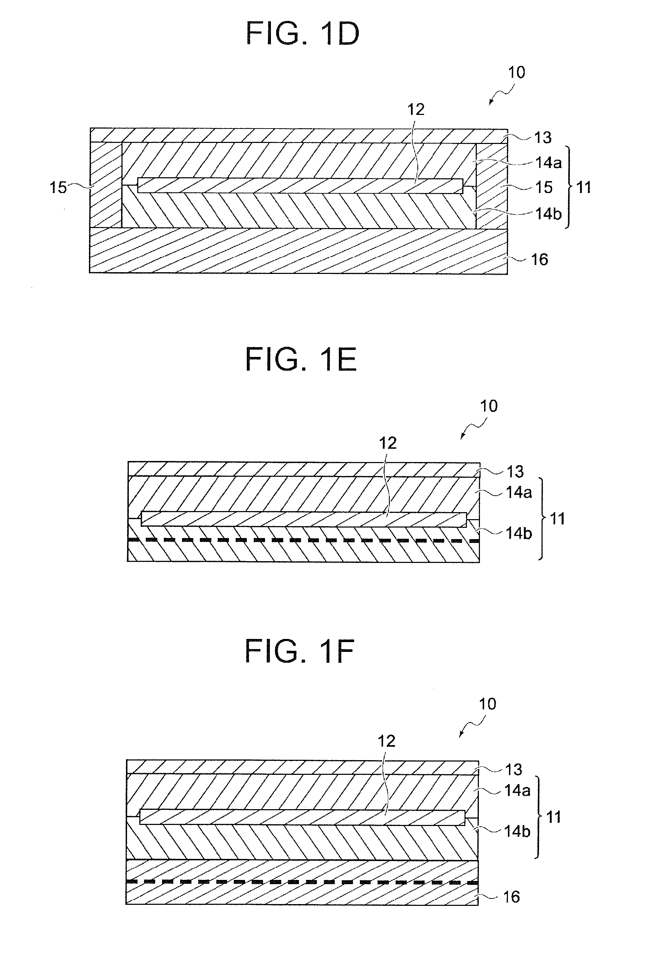

Moreover, as a fourth embodiment, as shown in FIG. 1D, there may be mentioned a stack of the surface protection layer 13, the solar cell module 11 whose main components are the encapsulation layer 14a, the solar cell element 12 and the encapsulation layer 14b, and the backsheet 16, including the sealing material 15 to seal the peripheral portion of the solar cell module 11.

Above-mentioned embodiments are typical embodiments of the roll screen 10, and therefore configurations different from those of the above-mentioned configurations can be suitably adopted for the solar-cell-integrated roll screen of the present invention. For instance, the roll screen 10 may include a reinforcing material. Further, the roll screen 10 may have an ultraviolet-cut layer, a gas barrier layer and/or a absorbent material layer. Each of the ultraviolet-cut layer, the gas barrier layer and the absorbent material layer may be the surface protection layer 13 itself, the encapsulation layer 14a itself, the encapsulation layer 14b itself or the backsheet 16 itself. The ultraviolet-cut layer, the gas barrier layer and the absorbent material layer may be prepared as the dedicated layers in arbitrary positions.

The sizes of the encapsulation layer 14a and the encapsulation layer 14b (each of which may hereinafter be referred to as the encapsulation layer 14) will not be limited providing that the layers can encapsulate the solar cell element 12. The sizes of the surface protection layer 13 and the back layer 16 are not particularly limited, but it is preferred that their sizes are same as or greater than the size of the encapsulation layer 14, and, from the viewpoint of producibility, it is especially preferred that their sizes are same as the size of the encapsulation layer 14. Further, when using the backsheet 16, it is preferable to configure the roll screen 10 so as to have an edge area where the backsheet 16 exists but the surface protection layer, the encapsulation layer, etc. do not exist. This is because the edge area allows the roll screen 10 to be fixed easily to another member such as a roller 30 of a roll screen device discussed later.

One feature of the present invention is that the roll screen 10 has specific physical properties. When the roll screen is unbound, tensile force is applied to the roll screen. Furthermore, when the roll screen is unbound, since the state of the roll screen changes from the state where the roll screen is curved along a roller into the state where the roll screen is extended in a plane, a bending force is applied to both sides of the solar cell module. Also when the roll screen is wound up, a tensile force is applied to the roll screen, and, since the state of the roll screen changes from the state where the roll screen is extended in a plane into the state where the roll screen is curved along the roller, bending stress is applied to both sides of the module.

On the other hand, the solar cell element includes weak materials, such as a transparent electrode, and has a complex layered structure. Accordingly, in order to impart durability for practical use to the roll screen, it is necessary to relax the stress generated when the roll screen is used. The present invention is one that, by managing the tensile strength of the roll screen or the tensile strength and Young's modulus of the roll screen, relaxes the stress to the solar cell element and keeps efficiency of the solar cell element.

### 1.1 Tensile strength

Tensile strength of the roll screen 10 of the present invention is less than or equal to 75 MPa. The tensile strength is preferably less than or equal to 60 MPa, more preferably less than or equal to 50 MPa, still more preferably less than or equal to 40 MPa, most preferably less than or equal to 35 MPa. By adjusting the tensile strength of the roll screen 10 to the above-mentioned upper limit or less, the bending stress and tension stress applied to the solar cell element when the roll screen 10 is unwound can be lowered, thereby lowering the damage of the solar cell element.

On the other hand, the tensile strength of the roll screen 10 is commonly greater than or equal to 5 MPa, preferably greater than or equal to 10 MPa, more preferably greater than or equal to 14 MPa, still more preferably greater than or equal to 20 MPa, most preferably greater than or equal to 25 MPa. By adjusting the tensile strength of the roll screen 10 to the above-mentioned lower limit or more, the strain within the roll screen when the roll screen 10 is pulled with a force of a fixed magnitude or more can be lowered, and therefore it will be possible to prevent the solar cell from being damaged easily.

The tensile strength of the roll screen 10 can be measured using a conventional tensile tester, but it is preferable to measure the tensile strength by using a method described later.

Further, to control the tensile strength of the roll screen 10 into a desired value (a value of 75 MPa or less), the thickness and quality of the material of one or more layers in the roll screen 10 are adjusted. Examples of layer that especially affects the tensile strength of the roll screen 10 are the surface protection layer 13 and the backsheet 16. If materials that surround the solar cell element 12 are soft, a reinforcing material (a material having a high tensile strength) can, if necessary, be stacked on the roll screen 10 in order to increase its strength into a fixed value or more. By arranging a material having a high tensile strength on the whole surface of the roll screen 10, the tensile strength can be controlled. Note that, when stacking a material having a high tensile strength on the roll screen, it is preferable to thicken a layer adjacent to the material having a high tensile strength in order to prevent a stress from being concentrated on some layer(s),

### 1.2 Young's modulus

Young's modulus of the roll screen 10 of the present invention is commonly less than or equal to 2000 MPa, preferably less than or equal to 1000 MPa, preferably less than or equal to 800 MPa, more preferably less than or equal to 650 MPa, and still more preferably less than or equal to 550 MPa.

When a bending stress is produced due to the winding of the roll screen, the roll screen repels against the bending stress with a stress proportional to the Young's modulus and opposite in direction to the bending stress. When the Young's modulus of the roll screen10 is less than or equal to the above-mentioned upper limit, stress against strain caused by unwinding the roll screen10 does not become too large. Therefore, the repellent force produced immediately after the unwinding of the roll screen 10 usually does not cause damage to the solar cell element. When the Young's modulus of the roll screen 10 exceeds the above-mentioned upper limit, there may be a case where the roll screen becomes too hard to be wound.

On the other hand, lower limit is commonly greater than or equal to 50 MPa, preferably greater than or equal to 100 MPa, more preferably greater than or equal to 250 MPa, still more preferably greater than or equal to 300 MPa, especially preferably greater than or equal to 350 MPa and most preferably greater than or equal to 355 MPa. When the Young's modulus of the roll screen 10 is greater than or equal to the lower limit, stresses produced within the roll screen when the roll screen is wound are cancelled out, and therefore it is possible to prevent the solar cell within the roll screen from being damaged. In contrast, when the Young's modulus of the roll screen 10 is less than the lower limit, the solar cell element is damaged easily, and the damage affects the electrical characteristics (amount of leakage currents, etc., especially, the decrease of FF) of the solar cell.

The Young's modulus of the roll screen 10 can be measured using a conventional tensile tester, but it is preferable to measure the tensile strength by using a method that will be described later.

The Young's modulus of the roll screen 10 can be controlled into the desired value (preferably a value of 650 MPa or less) by adjusting suitably the thickness and the quality of material of one or more layers of the roll screen 10. As layers that especially affect the Young's modulus of the roll screen 10, there may be mentioned inside layers arranged near the solar cell element. Namely, the encapsulation layers 14 are the layers that especially affect the Young's modulus of the roll screen 10.

By selecting materials having a high Young's modulus as the materials for these layers, the Young's modulus of the roll screen 10 can be increased. Moreover, the Young's modulus of the roll screen 10 can be controlled by adjusting the thickness of the above-mentioned layer(s) so that the Young's modulus of the roll screen 10 may not become too high. The Young's modulus of the roll screen 10 also can be controlled by selecting a material having a low Young's modulus as a material for a layer and thickening its adjacent layer. Specifically, the Young's modulus of the roll screen 10 can be controlled to the desired value by adjusting the thickness of each layer within a specific range, preferably a range for each layer described later, which is determined so as not to impair function of each layer.

To relax the stress produced in each layer, the encapsulation layer is better to have thickness more than a fixed value. However, when the encapsulation layer is thickened too much, there may be a case where deformation strain against bending when being wound increases, which gives opposite effect. The encapsulation layer has an effect that it keeps adhesiveness of adjacent interfaces by relaxing stress. Consequently, when the encapsulation layer is too thin, adhesive failure, such as exfoliation, may occur while the roll screen is in use because the above effect is not achieved.

Further, when the roll screen 10 does not include the surface protection layer or includes the surface protection layer but too thin, the Young's modulus of the roll screen 10 tends to decrease, and excoriation resistance of the roll screen also tends to decrease. On the other hand, when the surface protection layer is too thick, there may be a case where the solar cell element is easily damaged because the Young's modulus of the roll screen 10 is too large.

When Young's modulus difference of the surface protection layer and the encapsulation layer is "the surface protection layer > the encapsulation layer," it is possible to facilitate adjustment of the Young's modulus of the whole roll screen by controlling their thicknesses so as to satisfy the relationship of "the surface protection layer < the encapsulation layer."

A reinforcing material may be inserted in order to increase the Young's modulus significantly. As the reinforcing material, a nonwoven fabric, such as a nonwoven glass fabric or a polyester nonwoven fabric, is usable. The reinforcing material may be either arranged so as to adjoin a material layer having comparatively low Young's modulus (for example, the encapsulation layer) within the roll screen, or introduced in such a material layer. With this, even if the reinforcing material has a high Young's modulus, the Young's modulus of the whole roll screen can be controlled easily. The Young's modulus of the roll screen can be controlled, especially by the thickness and/or the density per unit area of the reinforcing material.

When the density of the reinforcing material is too low, a desired effect of increasing Young's modulus of the roll screen 10 cannot be achieved, and when the density of the reinforcing material is too high, there is a possibility that the control of Young's modulus of the roll screen 10 may become difficult.

### 1.3 Thickness and size

The thickness of the roll screen is commonly greater than or equal to 0.2 mm, preferably greater than or equal to 0.4 mm, more preferably greater than or equal to 0.6 mm, still greater than or equal to 0.8 mm. Further, the thickness is commonly less than or equal to 1.8 mm, preferably less than equal to 1.7 mm, more preferably less than equal to 1.6 mm, still more preferably less than equal to 1.4 mm and most preferably less than equal to 1.2 mm. If the thickness of the roll screen is greater than or equal to the above lower limit, the appearance hardly changes when being subjected to a winding/unwinding test. Moreover, if the thickness of the roll screen is greater than or equal to the above lower limit, stress applied to the solar cell element when the roll screen 10 is wound can be released easily, and therefore it is possible to prevent the solar cell element 12 to be damaged. If the thickness is less than or equal to the above upper limit, since the distortion produced when the roll screen 10 is wound up decreases, it is possible to prevent the solar cell element 12 to be damaged.

Further, the size of the roll screen 10 is commonly greater than or equal to 50 x 60 (3000 cm²), preferably greater than or equal to 70 x 100 (7000 cm²), more preferably greater than or equal to 80 x 120 (9600 cm²), most preferably greater than or equal to 100 x 150 (15000 cm²).

The length of the roll screen 10 is commonly greater than or equal to 50 cm, preferably greater than or equal to 70 cm, more preferably greater than or equal to 80 cm and most preferably greater than or equal to 100 cm.

The width of the roll screen 10 is commonly greater than or equal to 60 cm, preferably greater than or equal to 100 cm, more preferably greater than or equal to 120 cm and most preferably greater than or equal to 150 cm.

If the size, length and width are greater than or equal to the above-mentioned lower limits, the roll screen will function as a solar cell whose output does not change drastically even if local defects arise in the solar cell element due to long-term use.

Hereinafter, each layer of the roll screen 10 is described in more detail.

### 1.4 Configuration of each layer of the roll screen 10

### (1) Solar cell element 12

The solar cell element 12 is simply required to be a solar cell element having some amount of flexibility (a solar cell element hard to break even if being applied bending stress repeatedly).

Accordingly, as the solar cell element 12, a so-called thin film solar cell element, specifically, an organic solar cell element, an amorphous silicon solar cell element, a compound semiconductor solar cell element, or the like, can be preferably used.

The solar cell element 12 generally includes at least a transparent electrode, a photoelectric conversion layer and a substrate. It seems that, when the solar cell element 12 is used for the solar-cell-integrated roll screen, the thicknesses of the transparent electrode and the substrate within the solar cell element affect the durability of the solar cell.

In particular, the thin film solar cell is very weak against an external stress because it has very thin electrodes (especially, the transparent electrode) and an inorganic semiconductor layer. Accordingly, by bending or pulling the roll screen, a local defect is produced in the solar cell within the roll screen easily. Then, finally, the produced local defects will affect performance (especially, fill factor) of the solar cell.

As the thickness of the transparent electrode decreases, the durability of the transparent electrode against bending becomes higher. Therefore, the thickness of the transparent electrode is commonly less than or equal to 200 µm, preferably less than or equal to 150 µm and more preferably less than or equal to 100 µm. It appears that the effect of the present invention can be get in cases where the transparent electrode is at least less than or equal to the above-mentioned upper limit.

Examples of the material for the transparent electrode are a conductive metal oxide such as an indium tin oxide (ITO), an indium zinc oxide (IZO) or the like, or a three-layered transparent conductive film (IMI) consisting of two transparent oxide films such as conductive metal oxides and a metal thin film sandwiched between them.

Incidentally, the solar cell element 12 has the transparent electrode on its light receiving surface, and a layer, for example, an inorganic oxide layer, used as the transparent electrode is weak against compressive stress. Accordingly, in order to prevent deterioration of the transparent electrode by compressive stress, it is preferable to adopt to the roll screen device (body part 100), which will be detailed later, a configuration where the roll screen 10 is wound onto the roller 30 in a condition that the light receiving surface side of the solar cell element 12 faces the outside.

As mentioned above, the solar cell element 12 usually has a substrate.

When the substrate of the solar cell element is too thick, strain caused by bending increases. Therefore, the thickness of the substrate is commonly less than or equal to 100 µm, preferably less than or equal to 50 µm, more preferably less than or equal to 25 µm and most preferably less than or equal to 15 µm.

Strain produced by bending the solar-cell-integrated roll screen can be relaxed by adjusting the thickness of the encapsulation layer, but, when the encapsulation layer is thickened too much, there is a risk that the bending stress imposed upon the solar cell element may increase inversely.

Therefore, it is preferable that a thickness ratio of the encapsulation material to the substrate of the solar cell is 2.3 or more. This will result in an effect that the encapsulation layer, which is adjacent to the solar cell, relieves damage to the solar cell which will be caused by the bending stress produced in the substrate when the roll screen is wound/unwound.

Hereinafter, an organic solar cell element, an amorphous silicon solar cell element and a compound semiconductor solar cell element, which are typical thin film solar cell elements, will be explained.

### (1-1) Organic solar cell element

The organic solar cell element is a solar cell element in which an organic semiconductor is used as the photoabsorption layer (photoelectric conversion layer). The roll screen is used in a way where only one edge thereof is fixed. Hence, for the roll screen, the organic solar cell element which is strong against impacts such as flaps is preferable. The organic solar cell element is preferable in view of obtaining good design because it can be colored if needed.

Although configuration of the organic solar cell element is not particularly limited, the organic solar cell element may include, for example, a substrate and a layer structure obtained by forming an electrode (anode), a buffer layer (hole extraction layer), a photoelectric conversion layer (organic active layer), a buffer layer (electron extraction layer) and an electrode (cathode) one after another. The organic solar cell element may be the one that has the layer structure on the substrate, or the one that has the substrate on the layer structure.

### • Electrodes

The anode and cathode are only required to be electrodes one of which is a transparent electrode having transparency, but they can be electrodes each having transparency. Here, "having transparency" means, "through which 40 % or more of sunlight passes." It is possible to stack two or more anodes or cathodes. Further, the anode and/or cathode can be subjected to a surface treatment(s) to improve properties (electrical properties, wetting characteristic, etc.).

### • Anode

Examples of material for the anode are a conductive metal oxide such as indium tin oxide (ITO), indium zinc oxide (IZO), etc.; a metal such as silver, gold, aluminum, etc.; a three-layered transparent conductive film (IMI) consisting of two transparent oxide films such as conductive metal oxides and a metal thin film sandwiched between them; a carbon material such as carbon nanotube, graphene, etc,; a conductive polymer doped with hetero atoms.

The thickness of the anode, though not particularly limited, is commonly greater than or equal to 10 nm, preferably greater than or equal to 20 nm and more preferably greater than or equal to 50 nm. On the other hand, the thickness is commonly less than or equal to 10 µm, preferably greater than or equal to 1 µm, and more preferably less than or equal to 500 nm. When the film thickness of the anode is 10 nm or more, a sheet resistance can be lowered, and, when the film thickness of the anode is 10 µm or less, light can be efficiently changed into electricity because the anode does not cause a reduction in optical transmittance. When the anode is the transparent electrode, it is necessary to select the film thickness so as to satisfy optical transmittance requirement and sheet resistance requirement.

The sheet resistance of the anode, though there are no particular restrictions, is commonly greater than or equal to 1 Ω/sq., and it is less than or equal to 1000 Ω/sq., preferably less than or equal to 500 Ω/sq. and more preferably less than or equal to 100 Ω/sq.

### • Cathode

The cathode is generally a conductive material having a work function greater than that of the anode.

Examples of material for the cathode are metals such as platinum, gold, silver, copper, iron, tin, zinc, aluminum, indium, chrome, lithium, sodium, potassium, cesium, calcium, magnesium, etc. or alloys of some of these metals; mineral salts such as lithium fluoride, cesium fluoride, etc.; metal oxides such as nickel oxide, aluminum oxide, lithium oxide, etc. These materials are preferable because they have low work functions. From the viewpoint of electrode protection, preferred anode materials are metals such as platinum, gold, silver, copper, iron, tin, aluminum, calcium, indium, etc., and alloys of some of these metals.

The film thickness of the cathode is, though not particularly limited, normally greater than or equal to 10 nm, preferably greater than or equal to 20 nm, more preferably greater than or equal to 50 nm. On the other hand, the film thickness of the cathode is normally less than or equal to 10 µm, preferably less than or equal to 1 µm, more preferably less than or equal to 500 nm. When the cathode is the transparent electrode, it is necessary to select the film thickness so as to satisfy optical transmittance requirement and sheet resistance requirement. When the film thickness of the cathode is greater than or equal to 10 nm, the sheet resistance can be lowered, and when the film thickness of the cathode is less than or equal to 10 µm, light can be efficiently changed into electricity because the anode does not cause a reduction in optical transmittance.

The sheet resistance of the cathode, though not particularly limited, is commonly less than or equal to 1000 Ω/sq., preferably less than or equal to 500 Ω/sq., father preferably less than or equal to 100 Ω/sq. The lower limit, though not particularly limited, is commonly greater than or equal to 1 Ω/sq.

### • Buffer layer

The buffer layer can be divide into a hole extraction layer and an electron extraction layer, and each extraction layer can be arranged between the organic active layer and one electrode. By providing the buffer layer, electron/hole mobility between the organic active layer and the electrode increases. Furthermore, the buffer layer is effective in preventing a short-circuit between the electrodes.

The hole extraction layer and electron extraction layer are arranged between the electrodes so that the organic active layer is put between them. The organic solar cell element may have both of the hole extraction layer and the electron extraction layer, or may have only either of them.

Of the extraction layers, the layer on the light receiving surface-side must have transparency, but both layers may have transparency. Here, "having transparency" means, "through which 40 % or more of sunlight passes." It is possible to stack two or more electron/hole extraction layers. Further, the electron/hole extraction layer can be subjected to a surface treatment(s) to improve properties (electrical properties, wetting characteristic, etc.).

### • Hole extraction layer

The film thickness of the hole extraction layer, though not particularly limited, is commonly greater than or equal to 2 nm and less than or equal to 500 nm. As material for the hole extraction layer, a conductive polymer, for sample, polythiophene, polypyrrole, polyaniline or the like doped with sulfonic acid, halogen, etc; a metal oxide with a high work function, such as molybdenum oxide or nickel oxide is used.

### • Electron extraction layer

The film thickness of the electron extraction layer, though not particularly limited, is commonly greater than or equal to 0.1 nm and less than or equal or more 500 nm. The material of the electron extraction layer is not particularly limited, the materials for the electron extraction layer include inorganic compounds and organic compounds. As the inorganic compounds, there may be mentioned alkali metal salts such as LiF, etc., n-type oxide semiconductors such as titanium oxide (TiOx), zinc oxide (ZnO), etc. As the organic compounds, there may be mentioned phenanthrene derivatives such as bathocuproine (BCP), bathophenanthrene (Bphen), etc.; phosphine compounds each of which has a double bond between phosphorus atom and oxygen atom or a double bond between phosphorus atom and sulfur atom; and phosphine compounds each of whose phosphorus atom is bonded with an aromatic hydrocarbon group or an aromatic heterocyclic group; and the like. Of these, the phosphine compounds each of whose phosphorus atom is bonded with an aromatic hydrocarbon group or an aromatic heterocyclic group are preferable.

### • Photoelectric conversion layer (organic active layer)

The organic active layer commonly contains a p-type semiconductor compound and an n-type semiconductor compound. As the types of layer configuration of the organic active layer, there exist a thin film stack type, a bulk hetero-junction type, a PIN type, etc. Among these, the bulk hetero-junction type where p-type semiconductor compound and n-type semiconductor compound are mixed together is preferred. The film thickness, though not particularly limited, is commonly greater than or equal to 10 nm, and it is commonly less than or equal to 10 µm. The method of forming the organic active layer is not particularly limited, but paint-on method, such as spin coating, die coating, gravure coating, dip coating, ink-jet coating, or the like, is desirable.

The p-type semiconductor compound is material from which a film that serves as p-type semiconductor capable of transporting holes can be formed. As material for the p-type semiconductor compound, pi conjugated polymeric material, small organic compound, or the like is preferably used. The p-type semiconductor compound may be either a component or a mixture of several components. The conjugated polymeric material is a polymer of a single type of pi-conjugated monomer or two or more different pi conjugated monomers. Examples of the monomers are thiophene optionally having a substituent, fluorene, carbazole, diphenyl thiophene, dithienothiophene, dithienosilole dithienothiophene cyclohexane, benzothiadiazole, thienothiophene, imide thiophene, benzodithiophene, etc. As for a molecular weight, 10,000 or more is preferable. The monomers can be combined either directly or via ethynyl group, asethynyl group, nitrogen atom, and/or oxygen atom. Since having durability against bending stress, the pi conjugated polymeric materials are preferable in that they have anti-shock property and durability against opening/closing of the roll screen.

As the small organic-semiconductor materials, there are mentioned condensed aromatic hydrocarbons, such as pentacene, naphthacene, etc.; oligothiophenes having for or more thiophen rings; porphyrin; porphyrin compounds, such as tetrabenzoporphyrin compound, etc.; metal complexes of the porphyrin compounds; phthalocyanine compounds; metal complexes of the phthalocyanine compounds; etc. The HOMO level of a the-type semiconductor is generally greater than or equal to -5.7 eV, and is commonly less than or equal to -4.6 eV.

There is no particular restrictions relating to the n-type semiconductor compound. Examples of the n-type semiconductor compound are fullerene compounds and their derivatives, condensed ring tetracarboxylic acid diimides, and the like. As the fullerenes, there may be mentioned C60, C70, and, as the fullerene compounds, there may be mentioned compounds synthesized by adding 2, 4 or 6 substitute groups to 2, 4 or 6 carbons of fullerene. In order to enable film formation by the paint-on method, the fullerene compound is desirable to dissolve well in some solvent. The LUMO level of the n-type semiconductor is commonly greater than or equal to -4.5 eV, and it is commonly less than or equal to -2.0 eV.

### • Substrate

The material for the substrate is not particularly limited so long as the substrate is not broken when being used as a component of the solar-cell-integrated roll screen. Any material which does not spoil performance of the solar cell remarkably can be used.

As the preferable examples of the substrate material, there are mentioned inorganic materials such as glass; organic materials such as polyethylene terephthalate, polyethylene naphthalate, polyether sulfone, polyimide, nylon, polystyrene, polyvinyl alcohol, ethylene vinyl alcohol copolymer, fluorine resin film, polyolefin such as polyethylene or polyvinyl chloride, cellulose, polyvinylidene chloride, aramid, polyphenylene sulfide, polyurethane, polycarbonate, polyallylate, polynorbornene, epoxy resin, etc.; paper material such as paper or synthetic paper; composite materials such as a metal, such as stainless steel, titanium, aluminum or the like, sandwiched between layers of insulating material, which are formed by coating or lamination.

There is no restrictions on the form of the substrate, and as the form of the substrate, a film form, a sheet form, or the like can be adopted. The film thickness, though not particularly limited, is normally greater than or equal to 5 µm, preferably greater than or equal to 20 µm, and it is normally less than or equal to 100 µm, and more preferably less than or equal to 50 µm. If the film thickness is greater than the above-mentioned lower limit, a possibility that the organic solar cell lacks enough strength can be decreased. It is therefore desirable for the film thickness to be greater than or equal to the above-mentioned lower limit. On the other hand, if the film thickness is less than or equal to the above-mentioned upper limit, it is possible to save costs and to reduce the weight. It is therefore desirable for the film thickness to be less than or equal to the above-mentioned upper limit.

### (1-2) Amorphous silicon solar cell element

The amorphous silicon solar cell element is a solar cell element that includes a photoelectric conversion layer by amorphous silicon. The amorphous silicon solar cell element has the advantage that it can absorb sunlight satisfactory even if being a thin film of about 1 micrometer in thickness. The amorphous silicon is amorphous material having a high durability against bending. Therefore, by adopting an amorphous silicon solar cell element as the solar cell element 12, it is possible to obtain the roll screen 10 which is thin and lightweight, and does not induces breakdown, performance degradation, etc. of the solar cell element 12 when being wound on the roller.

Although the configuration is not particularly limited, the amorphous silicon solar cell element includes, for example, a substrate and a layer structure having two electrode (anode and cathode) and a photoelectric conversion layer sandwiched with the two electrode. At least one of the electrodes is a transparent electrode, and, as the transparent electrode, as with the above-mentioned organic solar cell, a conductive metal oxide such as an indium tin oxide (ITO), an indium zinc oxide (IZO), or the like, or a three-layered transparent conductive film (IMI) consisting of two transparent oxide films, such as conductive metal oxides, and a metal thin film sandwiched between them can be used. As the substrate, it is possible to use the same substrate as that the above-mentioned organic solar cell element can include. The photoelectric conversion layer is preferable to have PIN structure.

### (1-3) Compound semiconductor solar cell element

The compound semiconductor solar cell element is a solar cell that includes a photoelectric conversion layer by compound semiconductor.

As the compound semiconductor solar cell element, a known compound semiconductor solar cell element can be used. Although the configuration is not particularly limited, the compound semiconductor solar cell element may have a configuration where an electrode, a buffer layer, a photoelectric conversion layer, an electrode and a substrate are stacked in this order. As the buffer layer, any layer known as the buffer layer for a compound semiconductor solar cell element, such as ZnO, CdS, etc. At least one of the electrodes is a transparent electrode. As the transparent electrode, as with the above-mentioned organic solar cell, a conductive metal oxide such as an indium tin oxide (ITO), an indium zinc oxide (IZO), or the like, or a three-layered transparent conductive film (IMI) consisting of two transparent oxide films, such as conductive metal oxides, and a metal thin film sandwiched between them can be used. As the substrate, it is possible to use the same substrate as that the above-mentioned organic solar cell element can include.

Among compound semiconductor based semiconductor solar elements, the group I-III-VI₂ semiconductor (chalcopyrite based) solar cell elements having a high photoelectric conversion efficiency are preferable. Especially, the group I-III-VI₂ semiconductor solar cell elements each having Cu as the group I element are preferable. Here, the group I-III-VI₂ semiconductor solar cell element is a solar cell element which has Cu-III-VI₂ semiconductor as its constituent material. The Cu-III-VI₂ semiconductor is a semiconductor that consists of compound containing Cu, group III element, and group VI element in the ratio of 1:1:2. Examples of the Cu-III-VI₂ semiconductor are CuInSe₂, CuGaSe₂, Cu (In₁₋ₓGaₓ)Se₂, CuInS₂, CuGaS₂, Cu (In₁₋ₓGaₓ)S₂, CuInTe₂, CuGaTe₂, and Cu(In₁₋ₓGaₓ)Te₂.

The constituent material of the compound semiconductor solar cell element used as the solar cell element 12 may be a mixture of two or more of these materials.

Note that, among the compound semiconductor solar cell elements, CIS based solar cell element and CIGS based solar cell element are particularly preferable. Here, the CIS based solar cell element is a solar cell element that has a CIS based semiconductor as its constituent material, and the CIS based semiconductor is CuIn(Se_{1-y}S_{y})₂ (0 ≤ y ≤ 1). That is, the CIS based semiconductor means CuInSe₂, CuInS₂, or a mixture of these substances.

Moreover, the CIGS based solar cell element is a solar cell element which has a CIGS based semiconductor as its constituent material, and the CIGS based semiconductor is Cu(In₁₋ₓGaₓ) (Se_{1-y}S_{y})₂ (0 < x < 1, 0 ≤ y ≤ 1). Incidentally, Cu(In₁₋ₓGaₓ)(Se_{1-y}S_{y})₂ is commonly a mixed crystal of CuInSe₂ and CuGaSe₂. Further, x is commonly greater than 0, preferably greater than 0.05, and more preferably greater than 0.1, and x is commonly less than 0.8, preferably less than 0.5, and more preferably less than 0.4.

### (2) Surface protection layers 13

The surface protection layer 13 is a layer for protecting the solar cell element 12 from breaks in the weather, and the like. If the solar-cell-integrated roll screen of the present invention is used outdoors, the solar-cell-integrated roll screen is preferable to have the surface protection layer. In the components of the solar cell element 12, there exist components that deteriorate due to temperature change, humidity change, natural light, erosion by wind and weather, etc. It is therefore preferable, in order to prevent the power generation performance from degrading, to protect the solar cell element 12, etc. from changes in weather, etc. by covering the solar cell element 12 with the surface protection layer 13.

Since the surface protection layer 13 is the top layer of the roll screen 10, It is preferred that the surface protection layer 13 has properties, such as weather resistance, heat resistance, transparency, water repellency, stain resistance, mechanical strength, etc., suitable for a surface coating material of the roll screen 10 (solar cell element 12) and also has a feature of maintaining the properties for a long time even if the roll screen 10 is placed outdoors.

It is preferred that the roll screen 10 can be wind up compactly. Therefore, the surface protection layer 13 with a thin thickness is preferable. The thickness of the surface protection layer 13 is commonly greater than or equal to 25 µm, preferably greater than or equal to 50 µm, and more preferably greater than or equal to 70 µm. Further, the thickness of the surface protection layer 13 is commonly less than or equal to 200 µm, preferably less than or equal to 180 µm, and more preferably less than or equal to 100 µm. When the thickness is less than or equal to the above-mentioned upper limit, flexibility of the roll screen 10 is increased, thereby resulting in the roll screen that can be wound up easily. On the other hand, when the thickness is greater than the above-mentioned lower limit, weather resistance can be ensured. It is therefore preferable for the thickness to be greater than or equal to the above-mentioned lower limit.

Further, the surface protection layer 13 is preferable to be a layer through which visible light permeates from the viewpoint that photoabsorption of the solar cell element 12 should not be disturbed. For instance, the light transmittance of the surface protection layer 13 for the visible light (wavelength range: 360-830 nm) is preferably greater than or equal to 80%, more preferably greater than or equal to 90%, and particularly preferably greater than or equal to 95%.

Moreover, since the roll screen 10 is frequently heated by incident light, it is proffered that the surface protection layer 13 also has durability against heat. From this viewpoint, the melting point of the constituent material of the surface protection layer 13 is commonly greater than or equal to 100 °C, preferably greater than or equal to 120 °C and more preferably greater than or equal to 130 °C, and it is commonly less than or equal to 350 °C, preferably less than or equal to 320 °C, and more preferably less than or equal to 300 °C. By raising the melting point, it is possible to reduce a possibility that the surface protection layer 13 melts and/or deteriorates.

Any material can be used to form the surface protection layer 13 so long as it can protect the solar cell element 12 from changes in the weather. Examples of material for the surface protection layer 13 are: polyethylene resins; polypropylene resins; cyclic polyolefin resins; AS (acrylonitrile-styrene) resins; ABS (acrylonitrile-butadiene-styrene) resins; polyvinyl chloride resins; fluororesins; polyester resins, such as polyethylenenaphthalates, polyethylenetelephthalates, etc,; phenol resins; polyacrylic resins; polyamide resins, such as various nylons; polyimide resins; polyamide-imide resins; polyurethane resins; cellulose based resins, silicone based resins; polycarbonate resins; etc.

Of these, fluororesins are preferable. Concrete examples of fluororesins include polytetrafluoroethylene (PTFE), tetrafluoroethylene perfluoroalkoxy vinyl ether copolymer (PFA), tetrafluoroethylene hexafluoropropylene copolymer (FEP), ethylene tetrafluoroethylene copolymer (ETFE), polychlorotrifluoroethylene (PCTFE), polyvinylidene fluoride (PVDF), polyvinyl fluoride (PVF), etc.

Further, it is possible to give the surface protection layer 13 an ultraviolet cutoff function, a heat cutoff function, an antifouling propertties, antifog properties, abrasion resistance properties, conductivity, antireflection properties, antiglare properties, a light diffusion function, a light scattering function, a wavelength conversion function, gas barrier properties, etc. Since the roll screen 10 is exposed to the strong ultraviolet radiation from the sun, it is preferable to give the roll screen 10 the ultraviolet cutoff function. The ultraviolet cutoff function can be given to the surface protection layer by forming, for example, by coating a layer having the ultraviolet cutoff function on the surface protection layer, or by introducing material for causing the ultraviolet cutoff function into the surface protection layer.

Incidentally, the surface protection layer 13 may be formed from a single material, or it may be formed from two or more materials. Further, the surface protection layer 13 can be either a monolayer or a stack of two or more layers.

Moreover, the surface protection layer 13 can be subjected to a surface treatment(s), such as corona treatment and/or plasma treatment, to improve adhesiveness to other layers.

It is preferred that the surface protection layer 13 is arranged outside as much as possible in the roll screen 10. The purpose is to be able to protect more components within the roll screen 10. Therefore, it is preferred that the surface protection layer 13 is arranged as the outermost layer of the roll screen 10.

Moreover, to abolish a possibility that the face on the indoor-side (the side where the solar cell element 12 is not arranged)of the backsheet 16 and the surface of the surface protection layer are brought into contact with each other when the roll screen 10 is wound, emboss processing can be performed on the surface of the surface protective layer 13. This emboss processing of the surface of the roll screen 10 suppresses reflection of the roll screen 10, and therefore it is effective also for obtaining the roll screen 10 not dazzling when viewed from the outside.

### (3) Encapsulation layer 14a and encapsulation layer 14b

The encapsulation layer 14a and encapsulation layer 14b (each of which will hereinafter also be referred to as the encapsulation layer 14) are layers for reinforcing the solar cell element 12. The solar cell element 12 is thin and therefore weak in strength. Consequently, the roll screen 10 tends to be weak in strength. However, with the encapsulation layer 14, it is possible to keep the strength of the solar cell element 12 high.

In order to be able to wind up the roll screen 10 compactly, the encapsulation layer 14 is preferable to be thin in thickness. The thickness of the encapsulation layer 14 is commonly greater than or equal to 120 µm, preferably greater than or equal to 200 µm and more preferably greater than or equal to 250 µm. Further, it is commonly less than or equal to 500 µm, preferably less than or equal to 450 µm and more preferably less than or equal to 400 µm. When the thickness is less than or equal to the above-mentioned upper limit, flexibility of the roll screen 10 is improved, thereby resulting in the roll screen that can be wound up easily. On the other hand, the thickness which is greater than the above-mentioned lower limit allows to facilitate ensuring of the strength of the roll screen.

Further, the encapsulation layer 14 is preferable to have a high strength from the viewpoint of maintenance of the strength of the roll screen 10. Although it is difficult to determine a specific strength of the encapsulation layer 14 unconditionally because it is also related with the strength of the surface protection layers 13, the backsheet, etc. other than the encapsulation layers 14, the encapsulation layer 14 is desired to have adhesiveness and strength which allow exfoliation and deformation not to occur at any portion of the roll screen even if the roll screen 10 is wound on the roller 30 or is unwound from it.

Further, the encapsulation layer 14a is preferable to be a layer through which visible light penetrates from the viewpoint that photoabsorption of the solar cell element 12 should not be disturbed. For example, the transmittance of the encapsulation layer 14a for the visible light (wavelength range: 360 - 830 nm) is commonly greater than or equal to 60 %, preferably greater than or equal to 70 %, more preferably greater than or equal to 75 %, still more preferably greater than or equal to 80 %, yet more preferably greater than or equal to 85 %, still yet more preferably greater than or equal to 90 %, yet still more preferably greater than or equal to 95 %, and yet still further preferably greater than or equal to 97 %, and it is commonly less than or equal to 99 %. When the transmittance is greater than or equal to the above-mentioned lower limit, it is possible to convert sunlight into electrical energy more efficiently. It is therefore preferred that the transmittance is greater than or equal to the above-mentioned lower limit.

On the other hand, since back-side components of the solar cell element are not required to allow visual light to permeate through. Consequently, as the encapsulation layer 14b, one through which visual light does not permeate may be used. The encapsulation layer 14a and the encapsulation layer 14b may be the same or different, but it is preferred that the layers are the same from the viewpoint of simplicity in their formation.

Furthermore, it is preferred that the encapsulation layers 14 have durability against heat because the roll screen 10 is frequently heated by incident light. From this viewpoint, the melting point of constituent material of the encapsulation layers 14 is commonly greater than or equal to 100 °C, preferably greater than or equal to 120 °C, and more preferably greater than or equal to 130 °C. By raising the melting point, it is possible to reduce a possibility that the encapsulation layer 14 melts and/or deteriorates when the roll scene device is used. Further, the melting point of the constituent material of the encapsulation layer 14 is commonly less than or equal to 350 °C , preferably less than or equal to 320 °C , and more preferably less than or equal to 300 °C.

As examples of material for the encapsulation layers 14, there are mentioned ethylene acetic acid vinyl copolymer (EVA), ethylene ethyl acrylate copolymer (EEA), ethylene methyl acrylate copolymer (EMA), ethylene methyl methacrylate copolymer (EMMA), ethylene methacrylic acid copolymer (EMAA), propylene ethylene alpha-olefin copolymer, ethylene alpha-olefin copolymer, urethane resin, butyral resin, ionomer resin, silicone resin.

The examples also include tetrafluoroethylene (TFE), hexafluoropropylene (HFP), vinylidene fluoride (VdF), fluoropolymer whose main ingredient is tetrafluoroethylene (TFE) or vinylidene fluoride (VdF). Of these, olefin based resins are cheap and has a low possibility of generating poisonous gas when accidentally being heated too much. Accordingly, olefin based resins are suitable for the encapsulation layer 14a of the roll screen device that is used indoors.

From the viewpoint of reducing the damage to the solar cell element, which is due to bending stress caused by winging or unwinding the roll screen, as material for the encapsulating layers 14, a crosslinkable encapsulation material is preferable. On the other hand, from the viewpoint of ease of opening/closing the roll screen, an uncrosslinkable encapsulation material is preferable in order to maintain flexibility.

### (4) Thickness ratio of encapsulation layer 14a to surface protection layer 13

It is anticipated that the interface between the surface protection layer 13 and the encapsulation layer 14a relieves the strain caused by bending. Therefore, the roll screen is preferable to have the surface protection layer. That is, the solar-cell-integrated roll screen having the surface protection layer, the encapsulation layer and the solar cell element layer stacked in this order is preferable. A thickness ratio of the encapsulation layer 14a to the surface protection layer 13, i.e., a thickness ratio of the encapsulation layer that is located between the surface protection layer 13 and the solar cell element 12 to the surface protection layer 13, is preferably less than or equal to 30, more preferably less than or equal to 20, and still more preferably less than or equal to 15. If the thickness ratio is the above-mentioned upper limit, the strain due to bending of the roll screen will be relaxed effectively, which allows FF not to be lowered when a roller diameter of the roll screen is small. The smaller the roller diameter is, the better the effect that can be achieved. This is because, when the thickness ratio of the encapsulation layer 14a to the surface protection layer is too large, the position of the interface between the surface protection layer and the encapsulation layer is too close to the surface protection layer-side surface. On the other hand, the thickness ratio of the encapsulation layer 14a to the surface protection layer 13 is preferable is greater than or equal to 0.5.

Moreover, it is possible to relieve the strain to the solar cell even if the thickness ratio of the encapsulation layer 14a to the surface protection layer 13 is small, as long as Young's modulus of the module is large. Specifically, the product of the Young's modulus in the winding direction and the thickness ratio of the encapsulation layer 14a to the surface protection layer 13 is preferably greater than or equal to 610, more preferably greater than or equal to 640, still more preferably greater than or equal to 1000, and most preferably greater than or equal to 1500.

### (5) Backsheet 16

The backsheet 16 includes a design layer and/or a back protection layer. The backsheet 16 may be either one layer or two or more layers. When the backsheet 16 has the design layer and the back protection layer, it is preferable to stack layers so that the back protection layer becomes the top surface on the indoor side. The backsheet 16 is commonly greater than or equal to 10 µm, preferably greater than or equal to 15 µm, and more preferably greater than or equal to 20 µm, and it is commonly less than or equal to 800 µm, preferably less than or equal to 500 µm, more preferably less than or equal to 300 µm. When the thickness is less than or equal to the above-mentioned upper limit, flexibility of the roll screen 10 is increased, thereby resulting in the roll screen that can be wound up easily. When the thickness is greater than the above-mentioned lower limit, weather resistance can be ensured. It is therefore preferable for the thickness to be greater than or equal to the above-mentioned lower limit. When the backsheet consists of only the design layer, the thicker one is preferable in order to ensure weather resistance.

### (5-1) Design layer

The design layer is a layer that is arranged in the back of the roll screen 10 and giving aesthetic sense to the surface on the indoor-side of the roll screen device.

In order to obtain the roll screen 10 that can be wound up compactly, the design layer is preferable to have a thin thickness. The thickness of the design layer is normally greater than or equal to 10 µm, preferably greater than or equal to 15 µm, and more preferably greater than or equal to 20 µm, and it is normally less than or equal to 800 µm, preferably less than or equal to 500 µm, and more preferably less than or equal to 300 µm.

Material for the design layer may be material created from a resin such as polypropylene or polyester, natural material such as Japanese paper, cotton or hemp. The material may be mixed spinning with synthetic fiber such as polyester and natural material such as cotton or hemp. The design layer may be either a layer having a high light blocking effect or a layer having a low light blocking effect (a translucent layer). Moreover, the design layer may have heat insulation properties.

Although the design layer may have any color, white, beige, brown, blue, green, etc. are suitably used from the viewpoint of aesthetic sense. Moreover, in order to enhance aesthetic sense, a surface(s), especially indoor-side surface, of the design layer can be decorated with a desired pattern. Moreover, in order to abolish a possibility that the face on the indoor-side (the side where the solar cell element 12 is not arranged)of the design layer and the surface of the surface protection layer 13 are brought into contact with each other when the roll screen 10 is would, emboss processing can be performed on the indoor-side surface of the design layer.

### (5-2) Back protection layer

It is preferred that the roll screen 10 has a back protection layer as the backsheet.

In order to obtain the solar cell module 10 that can be wound up compactly, it is preferred that the back protection layer has a thin thickness. The thickness of the back protection layer is commonly greater than or equal to 10 µm, preferably greater than or equal to 15 µm and more preferably greater than or equal to 20 µm, and it is commonly less than or equal to 200 µm, preferably less than or equal to 180 µm and more preferably less than or equal to 150 µm. By thinning the design layer, flexibility of the roll screen 10 is increased, thereby resulting in the roll screen that can be wound up easily. However, when the thickness is too thin, weather resistance can not be ensured. It is therefore unpreferable that the thickness is too thin.

The back protection layer is the same layer as the surface protection layer 13 mentioned above. Although they are different in positions, a layer that can be used as the surface protection layer 13 also can be used as the back protection layer as the surface protection layer 13 in the same manner as in the case of the surface protection layer 13. Since back-side components of the solar cell element are not required to allow visual light to permeate through, as the design layer, one through which visual light does not permeate may be used. Consequently, sheet of one of the following resins can be used for the back protection layer.

Examples of constitute material of the sheet for the back protection layer are sheets of polyethylene based resins, polypropylene based resins, cyclic polyolefin based resins, polystyrene based resins, acrylonitrile styrene copolymers (AS resins), acrylonitrile butadiene styrene copolymers (ABS copolymers), polyvinyl chloride based resins, fluorine based resins, poly (meth) acrylic based resins, polycarbonate based resins, polyester based resins such as polyethylene terephthalate and polyethylene naphthalate, polyamide resins such as various nylons, etc., polyimide based resins, polyamide imide based resins, polyaryl phthalate based resins, silicone based resins, polysulfone based resins, polyphenylene sulfide based resins, polyether sulfone based resins, polyurethane based resins, acetal based resins, cellulose based resins, and the like.

Of these resin sheets, sheets of fluorine based resins, cyclic polyolefin based resins, polycarbonate based resins, poly (meth) acrylic based resins, polyamide based resins, polyester based resins are preferable. Concrete examples of fluorine based resins are polytetrafluoroethylene (PTFE), tetrafluoroethylene perfluoroalkoxy vinyl ether copolymer (PFA), tetrafluoroethylene hexafluoropropylene copolymer (FEP), polyethylene tetrafluoroethylene copolymer (ETFE), polychlorotrifluoroethylene (PCTFE), polyvinylidene fluoride (PVDF), polyvinylfluoride (PVF). Note that the sheet for the back protection layer can be formed from a single resin among these resins. The sheet can also be formed from arbitrary combination of two or more resins among these resins in arbitrary ratio.

### (6) Sealing material 15

The sealing material can be used to seal the edge portion of the surface protection layer 13, the encapsulation layers 14a and 14b, and the backsheet 16. As shown in FIG. 1D, the form where the encapsulation layers 14a and 14b and the sealing material 15 are sandwiched with the surface protection layer 13 and the backsheet 16 is preferable.

It is preferred that the sealing material has durability against heat because the roll screen 10 is frequently heated by incident light. From this viewpoint, the melting point of constituent material of the sealing material is commonly greater than or equal to 100 °C, preferably greater than or equal to 120 °C, and more preferably greater than or equal to 130 °C, and it is commonly less than or equal to 250 °C, preferably less than or equal to 200 °C, and more preferably less than or equal to 180 °C. If the melting point is too low, the sealing material may melt when the roll screen 10 is used.

As materials for constituting the sealing material, there are mentioned, for example, polymers such as fluorine based resins, silicone resins, acrylic based resins and the like. Incidentally, the sealing material may be formed either from one material, or from two or more materials.

The sealing material is provided so as to seal every layers of the roll screen 10, excluding the surface protection layer 13. With this, it is possible to seal a space surrounded by the sealing material and to prevent moisture and oxygen and moisture from intruding into the space. The space surrounded by sealing material by this is sealed, and humidity and oxygen can be prevented from invading in this space.

The sealing material can be formed using various methods. For example, the sealing material can be formed by pouring its constituent material in between the surface protection layer 13 and the backsheet.

### (7) Reinforcing material

The roll screen 10 is a member that is frequently wound or unbent. Moreover, the roll screen 10 is heated by the sunlight from a window and the temperature of which sometimes reaches to be high. Under such a use condition, layers such as the encapsulation layer 14a, etc. are warped or curved readily, and creep may occur in the layers. Such deformation is likely to occur particularly in the fringe part of the roll screen 10, a reinforcing material may be provided in the roll screen 10.

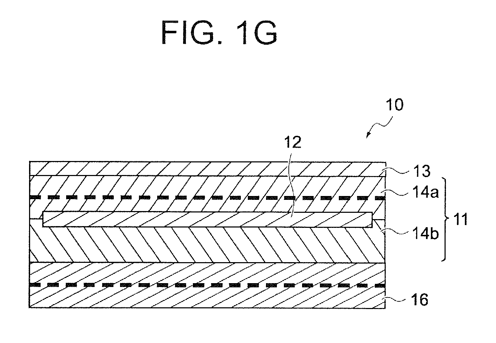

The reinforcing material is commonly provided in the surface protection layer 13, the encapsulation layer 14a, the encapsulation layer 14b, and/or the backsheet. The reinforcing material is preferably contained in the encapsulation layer 14a, the encapsulation layer 14b and/or the backsheet, more preferably contained in the encapsulation layer 14a (FIG. 1E), in the backsheet 16 (FIG. 1F), or in the encapsulation layer 14a and the backsheet 16 (FIG. 1G). The reinforcing material is especially preferably contained in the encapsulation layer 14b or the backsheet 16, most preferably in the backsheet 16. Note that the roll screen 10 may include another layer of a reinforcing material between the encapsulation layer 14b and the backsheet 16.

The thickness of the reinforcing material is commonly greater than or equal to 30 µm and preferably greater than or equal to 50 µm, and it is commonly less than or equal to 300 µm and less than or equal to 250 µm. If the reinforcing material is a mesh, the thickness of the reinforcing material is the maximum thickness of the mesh. The density per unit aria of the reinforcing material is commonly greater than or equal to 0.5 mg/m², preferably greater than or equal to 1 mg/m², and greater than or equal to 2 mg/m², and it is commonly less than or equal to 50 mg/m², preferably less than or equal to 30 mg/m², and less than or equal to 20 mg/m². If the density of the reinforcing material is too low, the effect of increasing the Young's modulus is weak, whereas if the density is too high, there is a possibility that control of the Young's modulus difficult.

As the reinforcing material, there are mentioned nonwoven fabric or weave which consists of inorganic fibers, such as glass or titanium, nonwoven fabric or weave which consists of organic fibers, such as polyamide, polyamide imide, polyimide, liquid crystalline polymer, aromatic amide or the like, or nonwoven fabric or weave which consists of mixed spinning of these.

Of these, glass fiber nonwoven fabric is used suitably. Moreover, when the nonwoven fabric is used in a way where it touches the encapsulation layers 14a and 14b, surfaces of the glass fibers may be treated with silane coupling agent to improve the adhesiveness of the interfaces between the sealing material resin and the glass fibers.

Examples of the silane coupling agent are vinyl trichlorosilane, vinyl triethoxysilane, vinyl trimethoxysilane, γ-methacryloxypropyltrimethoxysilane, γ-glycidoxypropylmethyldiethoxysilane, γ-aminopropyltriethoxysilane, γ-chloropropyl trimethoxysilane, etc. As concrete treatment methods, there may be mentioned a spray method of spraying alcohol or aqueous solution of silane coupling agent upon a nonwoven fabric, a dipping method of dipping a nonwoven fabric in the solution, a gravure coat method of passing a nonwoven fabric between rollers wet with the solution.

Forms usable for the reinforcing material include a form of covering the whole solar cell element 12 like the encapsulation layer 14a or 14b, and a form of reinforcing only the fringe part of the roll screen 10.

### (8) Other layers

The solar-cell-integrated roll screen of the present invention may include a gas barrier layer, an absorbent material layer, and an ultraviolet absorption layer in addition to the above-mentioned layers. These layers can be formed at arbitrary positions in accordance with their purposes.

Each of the layers is described below:

### (8-1) Gas barrier layer

The gas barrier layer is a layer for preventing permeation of water and oxygen. The solar cell element 12 is apt to be affected by humidity and oxygen. In particular, the transparent electrode such as ZnO:Al, the compound semiconductor solar cell element and the organic solar cell element may deteriorate due to water and oxygen. It is therefore preferable to protect the solar cell element 12 from water and oxygen by covering the solar cell element 12 with the gas barrier layer,

The thickness of the gas barrier layer, though not particularly limited, is preferable to have a thin thickness because it is desired that the roll screen 10 can be wound up compactly. The thickness of the gas barrier layer is commonly greater than or equal to 10 µm, preferably greater than or equal to 15 µm, and more preferably greater than or equal to 20 µm, and it is commonly less than or equal to 200 µm, preferably less than or equal to 180 µm, and more preferably less than or equal to 150 µm. When the thickness is less than or equal to the above-mentioned upper limit, flexibility of the roll screen 10 is increased, thereby resulting in the roll screen that can be wound up easily. When the thickness is greater than the above-mentioned lower limit, it becomes easier to secure the barrier properties. It is therefore preferable for the thickness to be greater than or equal to the above-mentioned lower limit.

The degree of the moisture-proof capability required to the gas barrier layer differs depending on the kind of the solar cell element 12, etc. For example, when the solar cell element 12 is the compound semiconductor solar cell element, the moisture vapor permeation rate per unit area (1 m²) per day is preferably less than or equal to 1x10⁻¹ g/m²/day, more preferably less than or equal to 1x10⁻² g/m²/day, still more preferably less than or equal to 1x10⁻³ g/m²/day, yet more preferably less than or equal to 1x10⁻⁴ g/m²/day, still yet more preferably less than or equal to 1x10⁻⁵ g/m²/day, and particularly preferably less than or equal to 1x10⁻⁶ g/m²/day. Further, when the solar cell element 12 is the organic semiconductor solar cell element, the moisture vapor permeation rate per unit area (1 m²) per day is preferably less than or equal to 1x10⁻¹ g/m²/day, more preferably less than or equal to 1x10⁻² g/m²/day, still more preferably less than or equal to 1x10⁻³ g/m²/day, yet more preferably less than or equal to 1x10⁻⁴ g/m²/day, still yet more preferably less than or equal to 1x10⁻⁵ g/m²/day, and particularly preferably less than or equal to 1x10⁻⁶ g/m²/day. When the moisture vapor permeation rate per unit area (1 m²) per day is low, deterioration of the solar cell element 12 and the transparent electrode such as ZnO:Al will lower, which allows the power generation efficiency to increase and also allows the lifetime to be prolonged.

The degree of the oxygen permeability required of the gas barrier layer differs depending on the kind of the solar cell element 12, etc. For instance, when the solar cell element 12 is the compound semiconductor solar cell element, the oxygen permeation rate per unit area (1 m²) per day is preferably less than or equal to 1x10⁻¹ cc/m²/day/atm, more preferably less than or equal to 1x10⁻² cc/m²/day/atm, still more preferably less than or equal to 1x10⁻³cc/m²/day/atm, yet more preferably less than or equal to 1x10⁻⁴cc/m²/day/atm, still yet more preferably less than or equal to 1x10⁻⁵ cc/m²/day/atm, and particularly preferably less than or equal to 1x10⁻⁶ cc/m²/day/atm. Further, for instance, when the solar cell element 12 is the compound semiconductor solar cell element, the oxygen permeation rate per unit area (1 m²) per day is preferably less than or equal to 1x10⁻¹ cc/m²/day/atm, more preferably less than or equal to 1x10⁻²cc/m²/day/atm, still more preferably less than or equal to 1x10⁻³cc/m²/day/atm, yet more preferably less than or equal to 1x10⁻⁴cc/m²/day/atm, still yet more preferably less than or equal to 1x10⁻⁵ cc/m²/day/atm, and particularly preferably less than or equal to 1x10⁻⁶ cc/m²/day/atm. The fewer the oxygen permeates, the less the deterioration of the transparent electrode, such as ZnO:Al, etc. by oxidization is.

Further, from the viewpoint that photoabsorption of the solar cell element 12 should not be disturbed, the gas barrier layer is preferable to be a layer through which visible light penetrates. For example, the transmittance for the visible light (wavelength range: 360 - 830 nm) is commonly greater than or equal to 60 %, preferably greater than or equal to 70 %, more preferably greater than or equal to 75 %, still more preferably greater than or equal to 80 %, yet more preferably greater than or equal to 85 %, still yet more preferably greater than or equal to 90 %, yet still more preferably greater than or equal to 95 %, and yet still further preferably greater than or equal to 97 %, and it is commonly less than or equal to 99 %. When the transmittance is greater than or equal to the above-mentioned lower limit, it is possible to convert sunlight into electrical energy more efficiently.

Moreover, since the roll screen 10 is frequently heated by incident light, it is proffered that the gas barrier layer also has durability against heat. From this viewpoint, the melting point of the constituent material of the gas barrier layer is commonly greater than or equal to 100 °C, preferably greater than or equal to 120 °C and more preferably greater than or equal to 130 °C, and it is commonly less than or equal to 350 °C, preferably less than or equal to 320 °C, and more preferably less than or equal to 300 °C. By raising the melting point, it is possible to reduce a possibility that the gas barrier layer melts and/or deteriorates.

The concrete configuration of the gas barrier layer can be any configuration as long as it can protect the solar cell element 12 from water. However, the fewer the desired permeation rate of a gas barrier layer for moisture vapor or oxygen is, the more the manufacturing cost of the gas barrier layer is. Therefore, it is preferable to select and use the suitable gas barrier layer by taking into these points into consideration.

As example of the suitable gas barrier layer, there may be mentioned a layer consisting of a resin layer such as polyethylene terephthalate (PET) or polyethylenenaphthalate (PEN) and SiOx (the value of x is 1.5 to 1.8) formed by vacuum deposition on the resin layer. It is possible to use AlOy (the value of y is 1.0 to 1.4) can be used instead of SiOx. It is also possible to form these two materials on the resin layer. Further, the resin layer that constitutes the gas barrier layer may be either a single layer or a stack of two or more layers.

### (8-2) Absorbent material layer

The absorbent material layer is a layer for absorbing water and/or oxygen. In the components of the solar cell element 12, there exist components which deteriorate by water and components which deteriorate by oxygen as mentioned above. Therefore, it is preferable to protect solar cell element 12 from water and/or oxygen by covering the solar cell element 12 with the absorbent material layer, and to control degradation of electric generating capacity.

Here, the absorbent material layer is not a layer, like the gas barrier layer, which prevents permeation of water but a layer which absorbs water. When the solar cell element 12 is covered with the gas barrier layer which absorbs water, the absorbent material layer catches the slight amount of water entered into the space formed by the gas barrier layer and the sealing material. Consequently, influence of the water on the solar cell element 12 can be eliminated.

The degree of the water absorption efficiency of the absorbent material layer is commonly greater than or equal to 0.1 mg/cm², preferably greater than or equal to 0.5 mg/cm², and more preferably greater than or equal to 1 mg/cm². By using the gas barrier layer having a high water absorption efficiency, the deterioration of the solar cell element 12 can be minimized. Further, the upper limit is, though not particularly limited, commonly less than or equal to 10 mg/cm².

When the solar cell element 12 is covered with the gas barrier layer which absorbs oxygen, the absorbent material layer catches the slight amount of oxygen entered into the space formed by the gas barrier layer and the sealing material. Consequently, influence of the oxygen on the solar cell element 12 can be eliminated.

The thickness of the absorbent material layer is, though not particularly limited, commonly greater than or equal to 5 µm, preferably greater than or equal to 10 µm, and more preferably greater than or equal to 15 µm, and it is commonly less than or equal to 200 µm, preferably less than or equal to 180 µm, and more preferably less than or equal to 150 µm. When the thickness greater is greater than or equal to the above-mentioned lower limit, the moisture absorptance of the absorbent material layer is usually ensured. When the thickness greater is less than or equal to the above-mentioned lower limit, flexibility of the roll screen 10 is usually ensured.

Furthermore, the absorbent material layer is preferable to be a layer through which visible light permeates from the viewpoint that photoabsorption of the solar cell element 12 should not be disturbed. For example, the transmittance for the visible light (wavelength range: 360 - 830 nm) is commonly greater than or equal to 60 %, preferably greater than or equal to 70 %, more preferably greater than or equal to 75 %, still more preferably greater than or equal to 80 %, yet more preferably greater than or equal to 85 %, still yet more preferably greater than or equal to 90 %, yet still more preferably greater than or equal to 95 %, and yet still further preferably greater than or equal to 97 %, in order to convert sunlight into electrical energy more efficiently.

Moreover, since the roll screen 10 is frequently heated by incident light, it is proffered that the absorbent material layer also has durability against heat. From this viewpoint, the melting point of the constituent material of the absorbent material layer is commonly greater than or equal to 100 °C, preferably greater than or equal to 120 °C and more preferably greater than or equal to 130 °C, and it is commonly less than or equal to 350 °C, preferably less than or equal to 320 °C, and more preferably less than or equal to 300 °C. By raising the melting point, it is possible to reduce a possibility that the absorbent material layer melts and/or deteriorates.

The absorbent material layer contains material which can absorb water and/or oxygen.
Examples of material that can absorb water are alkali metals, alkaline earth metals; oxides of alkaline earth metals; hydroxides of alkali metals or alkaline earth metals; silica gel; zeolite based compounds; hydrosulfates such as sulfate magnesium sulfate, sodium sulfate, nickel sulfate or the like; aluminum metal complexes; organometallic compounds of aluminum oxide octylate, etc.; and the like. Specifically as alkaline-earth metals, Ca, Sr, Ba, etc. are mentioned. As oxides of alkaline-earth metals, CaO, SrO, BaO, etc. are mentioned. In addition, Zr-Al-BaO, aluminum metal complexes, etc. are also mentioned. As concrete brand names, there mentioned OleDry (manufactured by Futaba Corporation), etc.

As materials which absorb oxygen, there may be mentioned activated carbon, silica gel, activated alumina, molecular sieve, magnesium oxide, iron oxide, etc. There also mentioned Fe, Mn, Zn, mineral salts such as sulfate, chloride salt, nitride, etc. of these metals.

The absorbent material layer is only required to contain material that can absorb water and/or oxygen. The absorbent material layer is usually a layer consisting of some of these materials or a layer of resin including some of these materials. Further, the absorbent material layer can be either a monolayer or a stack of two or more layers.

As the resins in which material capable of absorbing water and/or oxygen is distributed or dissolved, polyethylene based resins, polypropylene based resins, cyclic polyolefin based resins, polystyrene based resins, acrylonitrile styrene copolymers (AS resins), acrylonitrile butadiene styrene copolymers (ABS resins), polyvinyl chloride based resins, fluorine based resins, poly (meth) acrylic based resins, polycarbonate based resins, etc. can be usable, for example. Of these, polyethylene based resins, fluorine based resins, cyclic polyolefin based resins, and polycarbonate based resins are preferable. It is possible to use only a single resin among these resins, or to use arbitrary combination of two or more resins among these resins in arbitrary ratio.

### (8-3) Ultraviolet-cut layer

The ultraviolet-cut layer is a layer which prevents permeation of ultraviolet radiation. In the components of the solar cell element 12, there exist components which deteriorate by ultraviolet radiation. Therefore, it is possible to use the ultraviolet-cut layer. For example, some of the gas barrier layers, which will be mentioned later, deteriorate by ultraviolet radiation. By using the ultraviolet-cut layer, the gas barrier layer, etc. can be protected from ultraviolet radiation, thereby keeping the performance of the gas barrier layer, etc. high.

It is desired that the roll screen 10 can be wound up compactly. Consequently, it is preferred that the ultraviolet-cut layer has a thin thickness. The thickness of the ultraviolet-cut layer is commonly greater than or equal to 5 µm, preferably greater than or equal to 10 µm, and more preferably greater than or equal to 15 µm, and it is commonly greater than or equal to 200 µm, preferably greater than or equal to 180 µm, and more preferably greater than or equal to 150 µm. By thickening the ultraviolet-cut layer, it is possible to increase the extent of absorption of ultraviolet radiation. However, the ultraviolet-cut layer too thick results in the roll screen that cannot be wound up compactly.

The permeation rate of ultraviolet radiation (for example, wavelength: 300 nm) required for the ultraviolet-cut layer is commonly less than or equal to 50 %, preferably less than or equal to 30 °C, particularly preferably less than or equal to 10 %.

Further, the ultraviolet-cut layer is preferable to be a layer through which visible light penetrates from the viewpoint that photoabsorption of the solar cell element 12 should not be disturbed. For example, the transmittance of the ultraviolet-cut layer for the visible light (wavelength range: 360 - 830 nm) is preferably greater than or equal to 80 %, more preferably greater than or equal to 90 %, and particularly preferably greater than or equal to 95 %.

Moreover, since the roll screen 10 is frequently heated by incident light, it is proffered that the ultraviolet-cut layer also has durability against heat. From this viewpoint, the melting point of the constituent material of the ultraviolet-cut layer is commonly greater than or equal to 100 °C, preferably greater than or equal to 120 °C and more preferably greater than or equal to 130 °C, and it is commonly less than or equal to 350 °C, preferably less than or equal to 320 °C, and more preferably less than or equal to 300 °C. When the melting point is too low, there is a possibility that the ultraviolet-cut layer melts when the roll screen 10 is in use.

Moreover, the ultraviolet-cut layer is preferable to be a layer which has high flexibility, has good adhesiveness with adjacent layers, and is capable of cutting moisture vapor and/or oxygen.

Any material can be used to constitute the ultraviolet-cut layer so long as it can reduce the intensity of ultraviolet radiation. Examples of the material are epoxy based, acrylic based, and urethane based resins containing ultraviolet absorber.

As the ultraviolet absorber, for example, salicylic acid based, benzophenone based, benzophenone based, or benzotriazole based ultraviolet absorber is usable. Among these, benzophenone based ultraviolet absorber and benzotriazole based ultraviolet absorber are preferable. As examples of these, there may be mentioned various aromatic organic compounds such as benzophenone based aromatic organic compounds and benzotriazoleseries based aromatic organic compounds. The ultraviolet absorber may be formed either from a single compound, or from two or more compounds.

The ultraviolet-cut layer can be either a monolayer or a stack of two or more layers. The ultraviolet-cut layer can be the surface protection layer 13, the encapsulation layer 14a, and/or the encapsulation layer 14b containing some of the above-mentioned ultraviolet absorbers. It is also possible to provide the ultraviolet-cut layer as the dedicated layer in an arbitrary position. The ultraviolet-cut layer is commonly arranged on the light receiving surface side of the solar cell element.

### (9) Burning resistance

It is preferable that material of each of layers which constitutes the roll screen 10 is a burning resist material. For example, material to which flame retardant material is added can be used to form the encapsulation layers 14a and 14b. The flame retardant material is not particularly limited. The flame retardant material can be either the inorganic flame retardant material or the organic flame retardant material. As the inorganic flame retardant materials, there may be mentioned antimony compounds, bromine compounds, metal oxides such as aluminum hydroxide and magnesium hydroxide. As the organic flame retardant materials, there may be mentioned pentabromodiphenyl ether, octabromodiphenyl ether, bromine compounds such as tetrabromobisphenol A and hexabromocyclododecane; phosphorus compounds such as triphenyl phosphate; red phosphorus; chlorine compound such as red phosphorus and chloroparaffin; etc. When the burning resistance material layer has low transparency, there is a risk that output of the solar cell decreases. Therefore, the burning resistance material layer is preferable to be a layer of the organic flame retardant material. Further, the organic flame retardant material has a risk of damaging the thin film solar cell element. Therefore, when the solar cell element is the thin film solar cell element, pentabromodiphenyl ether, octabromodiphenyl ether, bromine compounds such as tetrabromobisphenol A and hexabromocyclododecane; phosphorus compounds such as triphenyl phosphate are preferable. On the other hand, from the viewpoint of their safety when being burned, the inorganic flame retardant materials are preferable.

To obtain the roll screen 10 having burning resistance or flame retardance, filling such as nonwoven grass fabric, silica, etc. can be add to portions other than solar cell element 12 of the roll screen 10. Further, the roll screen 10 may include a pigmented layer. The pigmented layer can be used between arbitrary layers in the roll screen 10. By using the pigmented layer, it is possible to change the color of the roll screen including the solar cell element 12 which has color into any color.

### 2. Manufacturing method of the roll screen 10

The roll screen 10 can be manufactured by various methods.

For example, the roll screen 10 can be manufactured by piling up films that are materials of the surface protection layer 13, the encapsulation layer 14a, the solar cell element 12, the encapsulation layer 14b and the backsheet, and unifying piled films with a conventional laminator. It is possible to obtain a stack containing the solar cell by piling up films that are materials of the surface protection layer 13, the encapsulation layer 14a, the solar cell element 12, the encapsulation layer 14b, and to bond the stack and the backsheet with adhesive agent if needed.

Further, a material for a layer such as the reinforcing material, the ultraviolet-cut layer, the gas barrier layer, the absorbent material layer, etc. may be laminated beforehand with the surface protection layer 13, encapsulation layer 14a, the solar cell element 12, encapsulation layer 14b or the backsheet 16, as needed.

Laminating can be carried out by known approaches, such as a heat lamination and a pressure lamination. The heat lamination is preferable in respect of characteristic of the roll screen.

When using the heat lamination, the heating temperature is commonly greater than or equal to 140 °C, preferably greater than or equal to 170 °C, and it is commonly less than or equal to 180 °C and preferably less than or equal to 130 °C. Further, the heating time is commonly greater than or equal to 10 min and preferably greater than or equal to 20 min, and it is commonly less than or equal to 100 min and preferably less than or equal to 90 min. The pressure is commonly greater than or equal to 0.001 MPa and preferably greater than or equal to 0.01 MPa, and it is less than or equal to 0.2 MPa and preferably less than or equal to 0.1 MPa. By adjusting the pressure within this rage, reliable encapsulation can be done. Moreover, by adjusting the pressure within this rage, protrusion of the encapsulation layers 14a and 14b from the side of the roll screen and reduction of the film thickness due to over-pressurization can be prevented. That is, size stability can

On the other hand, if the heat resistance of the solar cell element is low, the pressure lamination is preferable. When using the pressure lamination, an adhesive agent may be used if needed. The type of the adhesive agent is not particularly limited so long as it does not affect winding/unwinding. It is possible to use any known adhesive agent, such as acrylic based resins, epoxy based resins, or silicone based resins, as the adhesive agent for the pressure lamination. It is possible to irradiate the roll screen with ultraviolet radiation and/or to heat the roll screen according to the kind of the adhesive agent or the backsheet. It is preferable to use the adhesive agent so that the thickness of the adhesive agent in the solar-cell-integrated roll screen becomes less than or equal to 20 µm.

Moreover, when the laminate containing the solar cell element is sticked on the backsheet, normally, the adhesive agent is applied on the backsheet, the surface protection layer, the encapsulation layer, the solar cell and the substrate are stacked on the backsheet, and then the stack is unified by pressure. It is preferable to use the same approach as the pressure lamination to unify the stack.

In order to abolish a possibility that the face on the side where the solar cell element 12 is not arranged (the indoor-side) of the back sheet and the surface of the surface protection layer 13 are brought into contact with each other when the roll screen 10 is wound, emboss processing can be performed on the indoor-side surface of the backsheet.

Moreover, it is proffered that the circumscription of the roll screen is not transparent from the viewpoint of purpose of the roll screen.

### 3. Solar-cell-integrated roll screen device

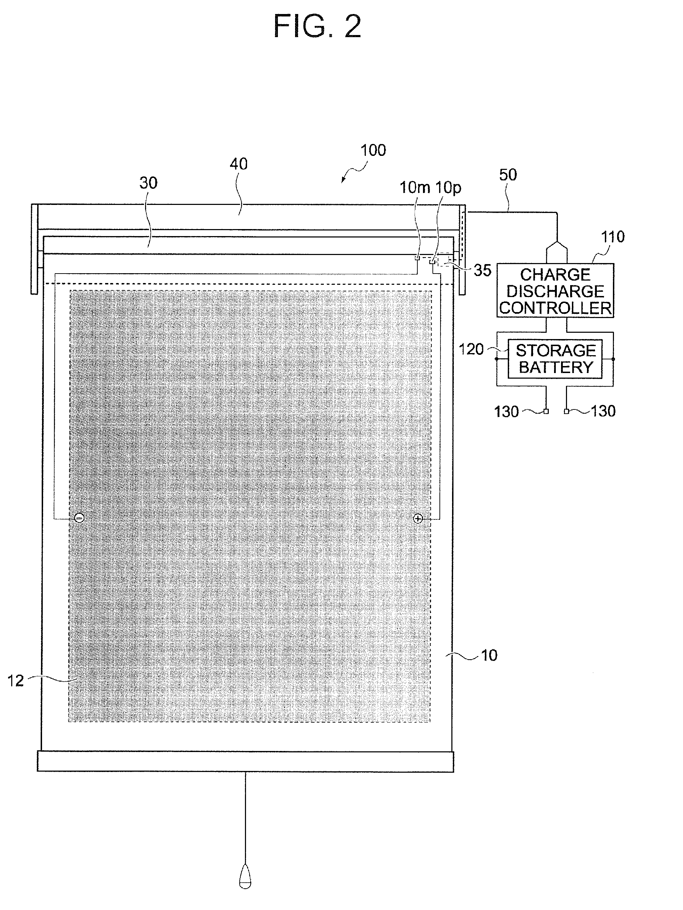

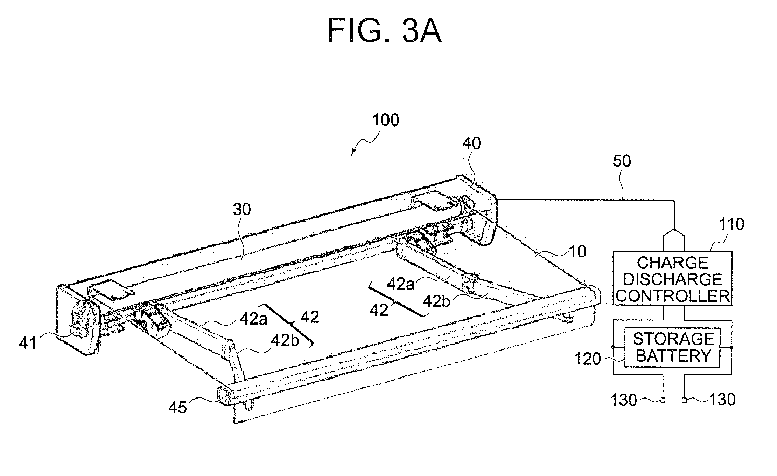

The roll screen 10 according to the embodiment can be used as a roll screen for the roll screen device shown in FIG. 2, or a roll screen for the roll screen device shown in FIG. 3A, The roll screen 10 also has a power-generation function equivalent to the conventional solar cell.

FIG. 2 illustrates an example of the roll screen device according to the embodiment. Two output terminals 130 provided in the roll screen device shown in FIG. 2 are terminals to which at least one equipment (a lighting equipment, etc) which operates at a DC voltage is to be connected. To each output terminal 130, one of output terminals of a storage battery 120 (and a charge-discharge controller 110) is connected

The charge discharge controller 110 is a circuit that charges the storage battery 120 with the electric power from the body part 100 (with the electric power that the solar cell element 12 in the roll screen 10 generates).

The body part 100 is a kind of a pull-cord type (spring type) roll screen device that consists of the roll screen 10, a roller 30 with which an end of the roll screen 10 is fixed, a retaining part 40, etc.

The retaining part 40 is a unit, which is made by combining members, to retain the roller 30 so that the roller 30 can rotate. When attaching the main body (roll screen device) 100 to a window, this retaining part 40 is fixed, directly or through other member, to the inside/outside of the frame of the window so that the backsheet 16 of the roll screen 10 faces the indoor side.

The roller 30 is a pipe-like member to wind up the roll screen10. The smaller the outside diameter of the roller 30 is, the more compactly the roll screen can be wound up. Consequently, by using the roller 30 having smaller outside diameter, it is possible to lessen the size of the retaining part 40. However, when the outside diameter of the roller 30 is too small, the strain in the roll screen 10 produced by being wound becomes large, and therefore a possibility that the solar cell element 12 is damaged when the roll screen 10 is wound/unwound increases. Consequently, the outside diameter of the roller 30 is commonly greater than or equal to 20 mm, preferably greater than or equal to 22 mm, more preferably greater than or equal to 30 mm, still more preferably greater than or equal to 40 mm, yet more preferably greater than or equal to 50 mm and most preferably greater than or equal to 70 mm. Increasing the outside diameter is also preferable at the point of maintenance of initial power generation efficiency. When the roller 30 having the outside diameter greater than or equal to 50 mm is used, the roll screen 10 of the present invention can exhibits, after the winding/unwinding test described later, at least 90 % or 95 % of the initial power generation efficiency. Moreover, when the roller 30 having the outside diameter greater than or equal to 70 mm is used, the roll screen 10 of the present invention can exhibits, after the winding/unwinding test described later, at least 95 % or 98 % of the initial power generation efficiency.

As mentioned above, as the outside diameter of the roller 30 increases, the strain in the roll screen 10 produced by being wound will increases, and therefore a possibility that the solar cell element 12 is damaged when the roll screen 10 is wound/unwound will decrease. However, if the outside diameter of the roller 30 is too large, it becomes difficult to set up the roll screen because weight and size of the roller 30 increases. Therefore, the outside diameter of the roller 30 is commonly less than or equal to 500 mm, preferably less than or equal to 400 mm, more preferably less than or equal to 300 mm, still more preferably greater than or equal to 200 mm, yet more preferably greater than or equal to 120 mm and most preferably greater than or equal to 100 mm.

Note that any material can be used as the constituent material of the roller 30. Examples of the constituent material for the roller 30 are metals such as aluminum and SUS, resins such as polyester resin, acrylic resin, methacrylate resin, and hard vinyl chloride.

In the roller 30, a biasing mechanism (not shown) to bias the roll screen 10 to rotate in the winding direction of the roller 30 is provided. In the roller 30, the braking mechanism (illustration abbreviation) to control the roller 30 so that the winding-up speed of the roll screen 10 is kept at or below a prescribed velocity (so that the winding-up speed is not increased too much). Furthermore, in the roller 30, a stop position control mechanism (not shown) to stop a rotation of the roller 30 at a state where only a part of the roll screen 10 is wound on the roller 30 (at one of states where lengths of the rolling screen 10 pulled out from the 30 differs each other). Note that these mechanisms are essentially the same as those prepared in the roller of the existing pull-cord type roll screen device. Therefore, the details of each mechanism are omitted.

In the roller 30, a rotary connector 35 (in this embodiment, 2 circuit rotary connector) is also provided. Two terminators on one side of the rotary connector 35 are connected with a cable 50 for supplying a power to the charge-discharge controller 110, and two terminators of the other side of the rotary connector 35 are connected with output terminals 10p and 10m of the roll screen 10. Herein, the output terminals 10p and 10m of the roll screen 10 are terminals connected with a cathode terminal and an anode terminal of the solar cell element 12, respectively.

FIG. 3A illustrates another example of the roll screen device according to the embodiment. Note that, in FIG. 3A, the solar cell element 12, etc. are omitted. In addition, parts that are not visual are also represented with solid lines.

Two output terminals 130 provided in the roll screen device shown in FIG. 3A are terminals to which at least one equipment (a lighting equipment, etc) which operates at a DC voltage is to be connected. To each output terminal 130, one of output terminals of a storage battery 120 (and a charge-discharge controller 110) is connected.

The charge discharge controller 110 is a circuit that charges the storage battery 120 with the electric power from the body part 100 (with the electric power that the solar cell element 12 in the roll screen 10 generates).

The body part 100 is a kind of a pull-cord type (spring type) roll screen device that consists of the roll screen 10, a roller 30 with which an end of the roll screen 10 is fixed, a retaining part 40, etc.

The retaining part 40 is a unit, which is made by combining members, to retain the roller 30 so that the roller 30 can rotate. When attaching the main body (roll screen device) 100 to a window, this retaining part 40 is fixed, directly or through other member, to the inside/outside of the frame of the window so that the backsheet 16 of the roll screen 10 faces the indoor side.

As shown in the figure, the retaining part 40 is provided with a member 41 extended in the direction of the axis of the roller 30, two arm parts 42, and the member 45 to which an end of the roll screen 10, which is not being fixed to the roller 30, is fixed.

Each arm part 42 provided in the retaining part 40 is a member that includes, as main components, a first arm 42a coupled to the member 41 through a joint member so as to be able to rotate on an end thereof, and a second arm 42b coupled to other end of the first art 42a through a joint member. To the joint member between the .first arm 42a and the second arm 42b of each arm part 42, a biasing member (coil spring etc.) for extending each arm part 42 is attached.

An end part of each arm part 42, which is not on the member 41 side, is fixed to the member 45 through a joint member

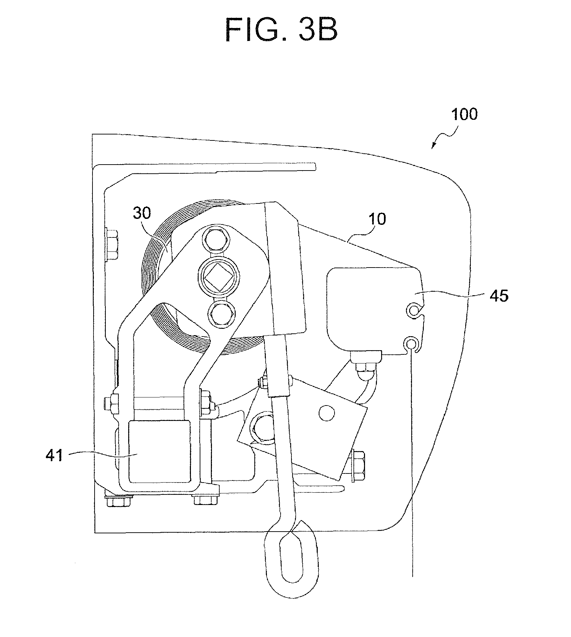

The retaining part 40 is also provided with a mechanism to rotate the roller 30. The mechanism may be either a mechanism that rotates the roller 30 based on electric power or a mechanism that rotates the roller 30 based on power applied by a user. Each arm part 42 of the retaining part 40 is designed and manufactured so that the member 45 can be drawn near to the place shown in FIG. 3B (in other word, so that the roll screen 10 can be wound up completely on the roller 30).

The roller 30 is a pipe-like member for winding the roll screen 10. The smaller the outside diameter of the roller 30 is, the more compactly the roll screen can be wound up. Consequently, by using the roller 30 having smaller outside diameter, it is possible to lessen the size of the retaining part 40. However, when the outside diameter of the roller 30 is too small, the strain in the roll screen 10 produced by being wound becomes large, and therefore a possibility that the solar cell element 12 is damaged when the roll screen 10 is wound/unwound increases. Consequently, the outside diameter of the roller 30 is commonly greater than or equal to 20 mm, preferably greater than or equal to 22 mm, more preferably greater than or equal to 30 mm, still more preferably greater than or equal to 40 mm, yet more preferably greater than or equal to 50 mm and most preferably greater than or equal to 70 mm. Increasing the outside diameter is also preferable at the point of maintenance of initial power generation efficiency. When the roller 30 having the outside diameter greater than or equal to 50 mm is used, the roll screen 10 of the present invention can exhibits, after the winding/unwinding test described later, at least 90 % or 95 % of the initial power generation efficiency. Moreover, when the roller 30 having the outside diameter greater than or equal to 70 mm is used, the roll screen 10 of the present invention can exhibits, after the winding/unwinding test described later, at least 95 %) or 98 % of the initial power generation efficiency

As mentioned above, as the outside diameter of the roller 30 increases, the strain in the roll screen 10 produced by being wound will increases, and therefore a possibility that the solar cell element 12 is damaged when the roll screen 10 is wound/unwound will decrease. However, if the outside diameter of the roller 30 is too large, it becomes difficult to set up the roll screen because weight and size of the roller 30 increases. Therefore, the outside diameter of the roller 30 is commonly less than or equal to 500 mm, preferably less than or equal to 400 mm, more preferably less than or equal to 300 mm, still more preferably greater than or equal to 200 mm, yet more preferably greater than or equal to 120 mm and most preferably greater than or equal to 100 mm.

Note that the constituent material of the roller 30 may be any material. As the constituent material for the roller 30, metal such as aluminum or SUS, resin such as polyester resin, acrylic, methacrylate resin, or hard vinyl chloride resin, or the like is usable.

In the roller 30, as with the above-mentioned roller 30 (FIG.2), a 2-circuit type rotary connector 35 (not shown) is provided. Two terminators on one side of the rotary connector 35 are connected with a cable 50 for supplying a power to the charge-discharge controller 110, and two terminators of the other side of the rotary connector 35 are connected with output terminals 10p and 10m of the roll screen 10. Herein, the output terminals 10p and 10m (see FIG.2) of the roll screen 10 are terminals connected with a cathode terminal and an anode terminal of the solar cell element 12, respectively.

Although the typical aspects of the roll screen device are discussed above, the solar-cell-integrated roll screen 10 of the present invention can be suitably used also to known roll screen devices other than the roll screen devices having the above-mentioned configuration.

The solar-cell-integrated roll screen of the present invention may have any known winding/unwinding mechanism.

As a system suitable for winding/unwinding the roll screen 10 of the present invention, there may be mentioned, for example, (i) a system wherein a unit (a spring, etc.) applies a certain force to the roller so that the roller rotates in the winding direction, and the roll screen is unwound from the roller when the bottom portion of the roll screen is pulled by a user.

There may also be mentioned, (ii) a system wherein the bottom portion of the roll screen is pulled downward mechanically or by gravity, and the roll screen is wound by rotating the roller.

When using these systems, a force in the winding/unwinding direction is always applied to the roll screen. The roll screen 10 of the present invention can prevent the solar cell from being damaged, not only when bending stress is generated in the roll screen 10 but tensile force is applied to the roll screen 10. Consequently, the solar-cell-integrated roll screen 10 can be suitably used in combination with each of the above-mentioned systems (i) and (ii).

The roll screen device of which the roll screen is unwound by pulling the bottom portion of the roll screen may be configured either as a device of which the roll screen is wound based on electric power, or as a device of which the roll screen is wound based on power applied by a user. Further, when a winding/unwinding speed of the roll screen is constant, deterioration distribution will not occur. Therefore, it is proffered that the solar-cell-integrated roll screen 10 is used in the device where a winding/unwinding speed of the roll screen is constant.

The roll screen device of which the roll screen is unwound by rotating the roller may be configured either as a device of which the roll screen is wound based on electric power, or as a device of which the roll screen is wound based on power applied by a user. When the weight of the solar-cell-integrated roll screen is heavy, it is preferable to adopt a system that the roll screen is unwound by its own weight. When the weight of the solar-cell-integrated roll screen is light, it is preferable to fix a member having a prescribed weight (for example, a cylindrical shaped member having the prescribed weight) to the bottom portion of the solar-cell-integrated roll screen.

### Examples

Hereinbelow, the present invention is further described below in detail with reference to the following examples, but it should be construed that the invention is in no way limited to those examples unless it deviates from the scope or spirit thereof.

The solar-cell-integrated roll screens having various configurations were manufactured, and the physical properties and performance of the solar-cell-integrated roll screens were evaluated with the following approaches.

The Young's modulus and tensile strength of each manufactured roll screen were measured by the following approaches.

### <Measurement method of Young's modulus and tensile strength>

### • Preparation of sample pieces

In order to measure the stress curve of each manufactured roll screen, a sample piece of each roll screen, which is compliant with the JIS K No. 6251-3, was made.

Specifically, the sample piece of each roll screen was made by scooping out it from the solar cell segment of each roll screen with a super dumbbell cutter (SDK-300 by DUMBBELL Co., Ltd.).

The tensile test to the sample piece of each roll screen was carried out at the crosshead speed of 50-mm/min using a tensile tester (STA-1225 by ORIENTEC CO. Ltd.).

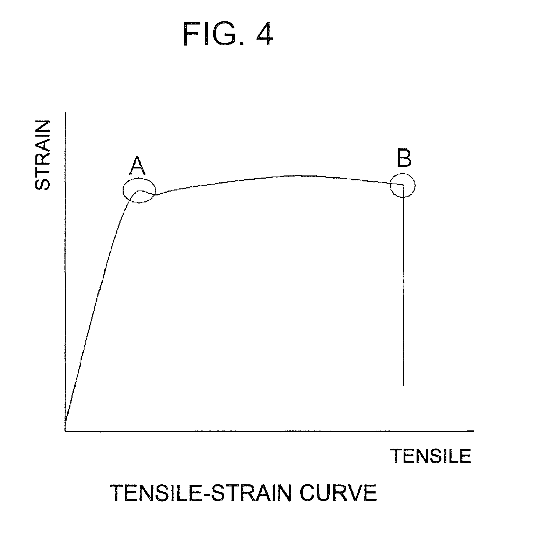

FIG. 4 shows a common stress curve (stress-strain curve) obtained by the tensile test. Thus, the stress curve exhibits a rapid linear rise of stress in the first region (region up to point A). The slope of the stress curve in the first region (elastic deformation region) was calculated as the Young's modulus of each roll screen.

The nominal stress curve exhibits a stress-plateau region (region from point A to point B) after the elastic deformation region, and after the resin, the sample piece will be ruptured. The maximum stress in this resin was measured as the tensile strength of the corresponding roll screen.

To evaluate the durability of the solar-cell-integrated roll screens, winding/unwinding tests were carried out by the following approaches.

### <Winding/unwinding test>

With respect to each of the manufactured roll screens (20 cm x 35 cm), a repetition operation "of fixing a short side part of the roll screen to a core so that the light receiving surface of the solar cell faces outside, and then repeating operation of winding and unwinding the roll screen 10 times" was done. The winding/unwinding test for one roll screen was conducted with respect to each of cores whose outside diameter are 90, 70, 42, 33 and 22 mm using each core in this order. Further, output measurement and appearance evaluation were carried out to each roll screen for every completion of the repetition operation. Note that the winding/unwinding test is defined as a test consisting of repetition operation, output measurement and appearance evaluation.

### <Output measurement of solar cell element>

The electrical characteristics of each roll screen as a solar cell after each wound/unwound test were measured with a simulator (by SERIC Co., Ltd.).

Specifically, in order to evaluate the degree of damage to the solar cell element caused by the flexible roll screen being bent repeatedly, the maximum output of each solar cell element was measured for every completion of the winding/unwinding test. Further, the fill factor (FF) of each solar cell element, which is subject to the damage of the solar cell element, was also measured for every completion of the winding/unwinding test.

### <Appearance evaluation>

The appearance of each roll screen was checked with eyes for every completion of the winding/unwinding test. Especially, the wrinkles might be formed on the module surface by winding. Therefore, the whole surface of each roll screen of 20 cm x 35 cm was checked carefully.

Hereinafter, the configuration and manufacturing method of each roll screen manufactured to develop the solar-cell-integrated roll screen having a high durability against winding/unwinding is explained.

### <Example 1>

A 100-µm-thick ETFE film (100 MW-DCS manufactured by Asahi Glass Co., Ltd.) as the outermost layer of the light receiving surface, a 200-µm-thick EVA film (F806 by Hangzhou First PV Materials Co., Ltd.) as the upper encapsulation layer, a 50-µm-thick PEN film having an amorphous silicon based power generation layer as the solar cell element, a 200-µm-thick EVA film (F806 by Hangzhou First PV Materials Co., Ltd.) as the lower encapsulation layer, a 100-µm-thick ETFE film (100 MW-DCS manufactured by Asahi Glass Co., Ltd.) as the outermost layer on the indoor side were stacked in this order, and then stacked films were united by thermal lamination vacuum: 80 Pa for 5 min, applying pressure for 5 min, holding for 10 min) at 150 µC with a vacuum laminator by NPC Inc., thereby manufacturing a roll screen (20 cm x 35 cm in size) of Example 1.

### <Example 2>

A roll screen was manufactured in the same way as in Example 1, except that a 200-µm-thick ETFE film was used as each of the outermost layer of the light receiving surface and the outermost layer on the indoor side.

### <Example 3>

A 50-µm-thick ETFE film (50 MW-DCS by Asahi Glass Co., Ltd.) as the outermost layer of the light receiving surface, a 300-µm-thick EVA film (FHCE by C. I. KASEI Co., Ltd.) as the upper encapsulation layer, a 50-µm-thick PEN film having an amorphous silicon based power generation layer as the solar cell element, a 70-µm-thick glass cloth (E05 by Nitto Boseki Co., Ltd.) as the reinforcing material, a 500-µm-thick EVA film (FHCE by C. I. KASEI Co., Ltd.) as the lower encapsulation layer, a 50-µmm-thick ETFE film (50 MW-DCS by Asahi Glass Co., Ltd.) as the outermost layer on the indoor side, were stacked in this order, and then stacked films were united by thermal lamination (vacuum: 80 Pa for 5 min, applying pressure for 5 min, holding for 10 min) at 150 °C with a vacuum laminator by NPC Inc., thereby manufacturing a roll screen (20 cm x 35 cm in size).

### <Example 4>

A roll screen was manufactured in the same way as in Example 3, except that a 170-µm-thick glass cloth (WLA90M100EV067 by Nitto Boseki Co., Ltd.) was used as the reinforcing material.

### <Example 5>

A roll screen was manufactured in the same way as in Example 3, except that a 500-µm-thick roll screen fabric (by Toso Co., Ltd.) was used as the outermost surface on the indoor side.

### <Example 6>

A 15-µm-thick ETFE film (V300 by Mitsubishi Plastics, Inc.) as the outermost layer of the light receiving surface, a 500-µm-thick EVA film (UFHCE by C. I. KASEI Co., Ltd.) as the upper encapsulation layer, a 50-µm-thick PEN film having an amorphous silicon based power generation layer as the solar cell element, a 500-µm-thick EVA film (UFHCE by C. I. KASEI Co., Ltd.) as the lower encapsulation layer, a 15-µm-thick ETFE film (V300 by Mitsubishi Plastics, Inc.) as the outermost layer on the indoor side, were stacked in this order, and then stacked films were united by thermal lamination (vacuum: 80 Pa for 5 min, applying pressure for 5 min, holding for 10 min) at 150 °C with a vacuum laminator by NPC Inc., thereby manufacturing a roll scene (20 cm x 35 cm in size).

### <Example 7>

A 50-µm-thick ETFE film (50 MW-DCS by Asahi Glass Co., Ltd.) as the outermost layer of the light receiving surface, a 100-µm-thick EVA film (EC-M0942) as the upper encapsulation layer, a 50-µm-thick PEN film having an amorphous silicon based power generation layer as the solar cell element, a 100-µm-thick EVA film (EC-M0942) as the lower encapsulation layer, a 50-µm-thick ETFE film (50 MW-DCS by Asahi Glass Co.) as the outermost layer on the indoor side, were stacked in this order, and then stacked films were united by thermal lamination (vacuum: 80 Pa for 5 min, applying pressure for 5 min, holding for 10 min) at 150 °C with a vacuum laminator by NPC Inc., thereby manufacturing a roll screen (20 cm x 35 cm in size) of Example 1.

### <Example 8>

A 200-µm-thick EVA film (F806 by Hangzhou First PV Materials Co., Ltd.) as the upper encapsulation layer, a 50-µm-thick PEN film having an amorphous silicon based power generation layer as the solar cell element, a 200-µm-thick EVA film (F806 by Hangzhou First PV Materials Co., Ltd.) as the lower encapsulation layer were stacked in this order, and then stacked films were united by thermal lamination (vacuum: 80 Pa for 5 min, applying pressure for 5 min, holding for 10 min) at 150 °C with a vacuum laminator by NPC Inc., thereby manufacturing a roll screen (20 cm x 35 cm in size) of Example 8.

### <Example 9>

A 50-µm-thick ETFE film (50 MW-DCS by Asahi Glass Co., Ltd.) as the outermost layer of the light receiving surface, a 800-µm-thick EVA film (a stack of 300-µm-thick and 300-µm-thick FHCEs by C. I. KASEI Co., Ltd.) as the upper encapsulation layer, a 50-µm-thick PEN film having an amorphous silicon based power generation layer as the solar cell element, a 800-µm-thick EVA film (a stack of 300-µm-thick and 300-µm-thick FHCEs by C. I. KASEI Co.) as the lower encapsulation layer, a 50-µm-thick ETFE film (50 MW-DCS by Asahi Glass Co., Ltd.) as the outermost layer on the indoor side, were stacked in this order, and then stacked films were united by thermal lamination (vacuum: 80 Pa for 5 min, applying pressure for 5 min, holding for 10 min) at 150 °C with a vacuum laminator by NPC Inc., thereby manufacturing a roll screen (20 cm x 35 cm in size) of Example 9.

### <Comparative Example 1>

A 50-µm-thick OPP film (P2002 by Toyobo Co., Ltd.) as the outermost layer of the light receiving surface, a 10-µm-thick EVA coating layer (EC-M0942 by CSC Co., Ltd.) as the upper encapsulation layer, a 50-µm-thick PEN film having an amorphous silicon based power generation layer as the solar cell element were stacked in this order, and then stacked films were united by thermal lamination (vacuum: 80 Pa for 5 min, applying pressure for 5 min, holding for 5 min) at 150 °C with a vacuum laminator by NPC Inc., thereby manufacturing a roll screen (20 cm x 35 cm in size) of Example 9.

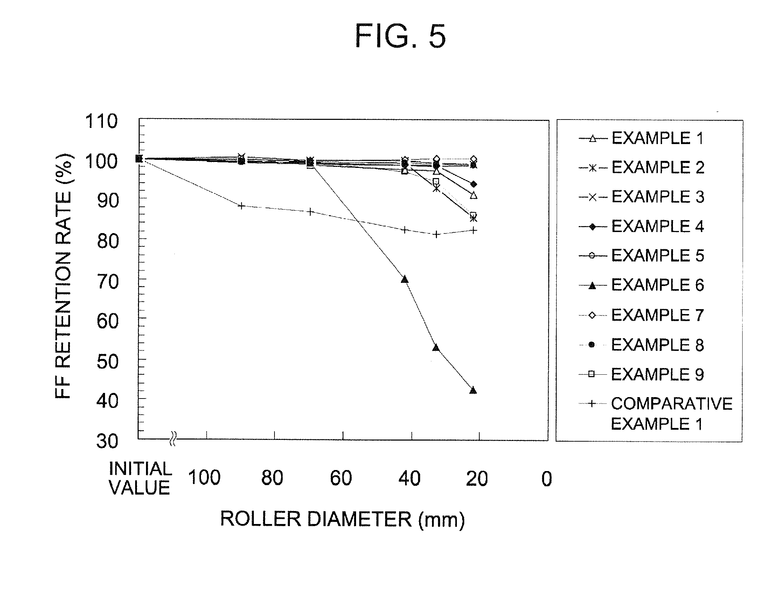

Tables 1 and 2 shows tensile strength, Young's modulus, thicknesses, results of the winding/unwinding tests of each of the roll screens of Examples. FIG. 5 shows FF retention ratios of Examples.

The FF retention ratio shown in FIG.5 is defined as a ratio of the FF of a roll screen which was determined in a winding/unwinding test to the FF of the roll screen which was determined before any winding/unwinding test for the roll screen was done (which will be hereinafter termed the initial FF).

The "FF retention ratio (DIA = 22 mm)" (see Table 2) is defined as a ratio of the FF of a roll screen which was determined in the winding/unwinding test using the core whose outside diameter is 20 mm to the initial FF of the roll screen. Hereinafter, the ratio of the FF of a roll screen which was determined in the winding/unwinding test using the core whose outside diameter is X mm to the initial FF of the roll screen is referred to as The FF retention ratio (DIA = X mm).

The meaning of the symbols in the "FF retention ratio (DIA = 22 mm)" column in Table 2 are as follows.

The "double circle" means that the "FF retention ratio (DIA = 22 mm)" is not less than 99 %.

The "circle" means that the "FF retention ratio (DIA = 22 mm)" is not less than 95 % and less than 99 %.

The "triangle" means that the "FF retention ratio (DIA = 22 mm)" is not less than 90 % and less than 95 %.

The "cross mark" means that the "FF retention ratio (DIA = 22 mm)" not less than 90 %.

The meanings of the symbols in the "FF retention ratio (DIA ≥ 70 mm)" column in Table 1 are as follows.

The "double circle" means that each of the "FF retention ratio (DIA = 70 mm)" and "FF retention ratio (DIA = 90 mm)" is not less than 99 %.

The "circle" means that each of the "FF retention ratio (DIA = 70 mm)" and "FF retention ratio (DIA = 90 mm)" is not less than 95 % and less than 99 %.

The "circle" means that each of the "FF retention ratio (DIA = 70 mm)" and "FF retention ratio (DIA = 90 mm)" is not less than 90 % and less than 95 %.

The "cross mark" means that each of the "FF retention ratio (DIA = 70 mm)" and "FF retention ratio (DIA = 90 mm)" is less than 90 %.

An initial maximum value of a roll screen is the maximum value of the roll screen which was determined before any winding/unwinding operation for the roll screen was done. Hereinafter, a ratio of the initial maximum value of the roll screen to the initial maximum value of the roll screen of Example 1 is referred to as an IVO ratio.

The meanings of the symbols in the "INITIAL MAXIMUM VALUE" column in Table 2 are as follows.

The "double circle" means that the IVO ratio is not less than 99 %.

The "circle" means that the IVO ratio is not less than 95 % and less than 99 %.

The "triangle" means that the IVO is not less than 90 % and less than 95 %.

The "cross mark" means that the IVO is less than 90 %.

The meanings of the symbols in the "appearance change (winkles)" column in Table 2 are as follows.

The "circle" means that appearance change was not observed.

The "cross mark" means that appearance change was observed.

**Table 1**

| | SOLAR-CELL-INTEGRATED ROLL SCREEN | | POWER GENERATION CHARACTERISTICS | |
|---|---|---|---|---|
| | TENSILE STRENGTH [MPa] | YOUNG'S MODULUS [MPa] | FF RETENTION RATIO (DIA ≥ 70mm) | INITIAL MAXIMUM OUTPUT |
| EXAMPLE 1 | 17.5 | 325 | ⊚ | ⊚ |
| EXAMPLE 2 | 20.1 | 351 | ⊚ | ⊚ |
| EXAMPLE 3 | 25.7 | 431 | ⊚ | ⊚ |
| EXAMPLE4 | 31.9 | 531 | ⊚ | ⊚ |
| EXAMPLE 5 | 29.5 | 359 | ⊚ | ⊚ |
| EXAMPLE 6 | 13.4 | 243 | ⊚ | ⊚ |
| EXAMPLE 7 | 28.1 | 678 | ⊚ | × (dec by 65%) |
| EXAMPLE 8 | 14.5 | 362 | ⊚ | ⊚ |
| EXAMPLE 9 | 8.6 | 152 | ⊚ | ⊚ |
| COMPARATIVE EXAMPLE 1 | 77.7 | 987 | × | × (dec by 17%) |

As shown in Table 1, the roll screens (Examples 1-9) each having the tensile strength lower than or equal to 75 MPa (i.e. within the scope of the present invention) hardly exhibited a reduction in the output when the roller diameter was greater than or equal to 70 mm. On the contrary, the roll screen (Comparative Example) having the tensile strength greater than 75 MPa exhibited a reduction in the output. These results reveal that the solar-cell-integrated roll screen of the present invention is the one of which the solar cell has a high durability.

Further, the initial maximum output of each roll screen (Example 1-6, 8, 9) whose Young's modulus in the winding direction was less than or equal to 650 Pa was higher than that of each roll screen (Example 7, Comparative Example) whose Young's modulus in the winding direction was greater than 650 Pa. Every roll screen was manufactured using the same solar cell element. Consequently, these results suggest that, by adjusting the Young's modulus in the winding direction to a value not less than 650 Pa, it is possible to manufacture the roll screen which is strong against force and/or pressure applied during the manufacturing process and produces a stable output.

As shown in FIG. 5 and Table 2, the FF retention ratio of the roll screen of Example 6, of which the thickness ratio of the encapsulation layer to the surface protection layer was greater than 30, decreased significantly when the roller diameter was changed into 40 mm. Note that the encapsulation layer in the "thickness ratio of the encapsulation layer to the surface protection layer" is the encapsulation layer on the surface protection layer-side of the solar cell element.

On the contrary, the FF retention ratio of each roll screen, of which the thickness ratio of the encapsulation layer to the surface protection layer was not greater than 30(Example 1-5, 7, 9), hardly changed when the roller diameter was changed into 40 mm. Accordingly, it can be said that, by manufacturing the roll screen so that the thickness ratio of the encapsulation layer to the surface protection layer is less than or equal to 30, it is possible to obtain the solar-cell-integrated roll screen which can prevent damage to the solar-cell-integrated solar cell element even if being used in combination with the roller with a small diameter.

**Table 2**

| | THICKNESS | | | THICKNESS RATIO (ENCAPSULATION LAYER/SURFACE PROTECTION LAYER) | YOUNG'S MODULUS [MPa] | THICKNESS RATIO × YOUNG'S MODULUS | EVALUATION RESULTS | |
|---|---|---|---|---|---|---|---|---|
| | SOLAR-CELL-INTEGRATED ROLL SCREEN [mm] | SURFACE PROTECTION LAYER [µm] | ENCAPSULATION LAYER [µm] | | | | APPEARANCE CHANGE (WRINKLES) | FF RETANTION RATIO (DIA=22mm) |
| EXAMPLE 1 | 0.86 | 100 | 200 | 2.0 | 325 | 649 | ○ | ○ |
| EXAMPLE 2 | 1.00 | 200 | 200 | 1.0 | 351 | 351 | ○ | Δ |
| EXAMPLE 3 | 1.00 | 50 | 300 | 6.0 | 431 | 2589 | ○ | ⊚ |
| EXAMPLE 4 | 1.01 | 50 | 500 | 10.0 | 531 | 5312 | ○ | ○ |
| EXAMPLE 5 | 1.10 | 50 | 300 | 6.0 | 359 | 2156 | ○ | ⊚ |
| EXAMPLE 6 | 1.07 | 15 | 500 | 33.3 | 243 | 8086 | ○ | x |
| EXAMPLE 7 | 0.35 | 50 | 100 | 2.0 | 678 | 1356 | × | ⊚ |
| EXAMPLE 8 | 0.45 | - | 200 | - | 362 | - | ○ | ⊚ |
| EXAMPLE 9 | 1.72 | 200 | 800 | 4.0 | 152 | 608 | ○ | Δ |
| COMPARATIVE EXAMPLE 1 | 0.16 | 50 | 10 | 0.2 | 987 | 197 | × | Δ |

Moreover, as shown in Table 2, among the roll screens of Example 1-5, 7 and 9, each roll screen, of which the product of the thickness ratio of the encapsulation layer to the surface protection layer and the Young's modulus was greater than or equal to 610, exhibited an especially small reduction in the output when the roller diameter was 22 mm. It is therefore suggested that the solar-cell-integrated roll screen to be used in combination with the roller with a small diameter should be manufactured, considering the product of the thickness ratio of the encapsulation layer to the surface protection layer and the Young's modulus.

Further, as shown in Table 2, on the roll screens of Example 7 and Comparative Example, wrinkles were formed. The thickness of each of these roll screens was less than 0.4 mm, and wrinkles were not formed on every roll screen whose thickness was greater than or equal to 0.4 mm. Consequently, it seems that the solar-cell-integrated roll screen should have a thickness greater than or equal to 0.4 mm.

The present invention is not limited to the embodiments, examples described above, and may be subject to various modifications within the scope of the invention described in the claims, with explicit understanding that such modifications are within the scope of the present invention. This application is based upon Japanese Patent Application No. 2010-289910, filed on December 27, 2012, and the Japanese Patent No. 2011-242865, filed on November 4, 2011, the entire contents of which are incorporated herein by reference.

### Reference Signs List

- 10: solar-cell-integrated roll screen
- 10p, 10n, 130: output terminal
- 11: solar cell module
- 12: solar cell element
- 13: surface protection layer
- 14a, 14b: encapsulation layer
- 15: reinforcement material
- 16: backsheet
- 30: roller
- 35: rotary connector
- 40: retaining part
- 50: cable
- 100: body part (roll screen device)
- 110: charge discharge controller
- 120: storage battery

## Claims

1. A solar-cell-integrated roll screen having a tensile strength in a winding direction less than or equal to 75 MPa.

2. The solar-cell-integrated roll screen according to claim 1, wherein Young's modulus in the winding direction is less than or equal to 650 MPa.

3. The solar-cell-integrated roll screen according to claim 1 or 2, having a thickness greater than or equal to 0.4 mm and less than or equal to 1.8 mm.

4. The solar-cell-integrated roll screen according to any one of claim 1 through 3, including a surface protective layer, an encapsulation layer and a solar cell element stacked in this order.

5. The solar-cell-integrated roll screen according to claim 4, wherein a thickness ratio of the encapsulation layer to the surface protective layer is less than or equal to 30.

6. The solar-cell-integrated roll screen according to claim 4 or 5, wherein a product of a thickness ratio of the encapsulation layer to the surface protective layer and the Young's modulus in the winding direction is greater than or equal to 610.

7. The solar-cell-integrated roll screen according to any one of claims 1 through 6, wherein the solar cell element is a thin film solar cell element.

8. A roll screen device, comprising the solar-cell-integrated roll screen according to any one of claims 1 through 7.

9. The roll screen device according to claim 8, further comprising a roller to wind up the solar-cell-integrated roll screen in a condition where a light receiving surface of the solar-cell-integrated roll screen faces toward outside.
